(19) Europäisches Patentamt
European Patent Office
Office européen des brevets

(11) **EP 4 618 540 A1**

(12) **EUROPEAN PATENT APPLICATION**
published in accordance with Art. 153(4) EPC

(43) Date of publication:
**17.09.2025 Bulletin 2025/38**

(51) International Patent Classification (IPC):
**H04N 19/172** (2014.01)    **H04N 19/159** (2014.01)
**H03M 7/40** (2006.01)

(21) Application number: **23937266.7**

(22) Date of filing: **14.11.2023**

(86) International application number:
**PCT/CN2023/131492**

(87) International publication number:
**WO 2024/234593 (21.11.2024 Gazette 2024/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.05.2023 CN 202310549379**

(71) Applicant: **Tencent Technology (Shenzhen) Company Limited**
**Shenzhen, Guangdong 518057 (CN)**

(72) Inventors:
• TIAN, Kuan
  Shenzhen, Guangdong 518057 (CN)
• ZHANG, Jun
  Shenzhen, Guangdong 518057 (CN)
• XIANG, Jinxi
  Shenzhen, Guangdong 518057 (CN)
• GUAN, Yonghang
  Shenzhen, Guangdong 518057 (CN)

(74) Representative: **EP&C**
**P.O. Box 3241**
**2280 GE Rijswijk (NL)**

(54) **DATA ENCODING METHOD AND APPARATUS, DATA DECODING METHOD AND APPARATUS, COMPUTER DEVICE, AND STORAGE MEDIUM**

(57) A data encoding method, comprising: acquiring auxiliary encoding information of feature data, and according to the auxiliary encoding information, determining a scale parameter value corresponding to each feature element comprised in the feature data (202); performing quantization processing on each scale parameter value to obtain a scale parameter quantization value corresponding to each scale parameter value, and screening for some scale parameter quantization values from the scale parameter quantization values according to a preset screening condition (204); extracting, from the plurality of feature elements comprised in the feature data, a feature element corresponding to each screened scale parameter quantization value (206); for each extracted feature element, performing entropy encoding on the feature element on the basis of the scale parameter quantization value corresponding to the feature element, to obtain encoded data corresponding to the feature element (208); and determining an encoded data stream of the feature data according to the encoded data (210).

Operation 202
Obtain auxiliary encoding information of feature data, and determine, according to the auxiliary encoding information, a scale parameter value corresponding to each feature element included in the feature data

Operation 204
Perform quantization processing on each scale parameter value, to obtain a scale parameter quantization value corresponding to each scale parameter value, and select a subset of scale parameter quantization values from the scale parameter quantization values according to a preset selecting condition, a selected scale parameter quantization value being greater than an unselected scale parameter quantization value

Operation 206
Extract, from a plurality of feature elements included in the feature data, a feature element corresponding to each scale parameter quantization value obtained through selection

Operation 208
Perform, for each feature element obtained through the extraction, entropy encoding on the feature element based on the scale parameter quantization value corresponding to the feature element, to obtain encoded data corresponding to the feature element

Operation 210
Determine an encoded data stream of the feature data according to the encoded data

FIG. 2

**Description**

RELATED APPLICATION

This application claims priority to Chinese Patent Application No. 2023105493790, filed on May 15, 2023 and entitled "DATA ENCODING METHOD AND APPARATUS, DATA DECODING METHOD AND APPARATUS, COMPUTER DEVICE, AND STORAGE MEDIUM".

FIELD OF THE TECHNOLOGY

This application relates to the field of computer technologies, and in particular, to a data encoding method and apparatus, a computer device, a storage medium, and a computer program product, and a data decoding method and apparatus, a computer device, a storage medium, and a computer program product.

BACKGROUND OF THE DISCLOSURE

With the development of computer technologies, data encoding and decoding technologies appear. Data can be compressed through encoding, and compressed data can be restored through decoding. The data encoding and decoding may be widely applied to various scenarios, and in particular, to a cross-platform data transmission scenario, for example, a real-time session application such as a video or voice chat or a video or voice conference.

Entropy encoding and entropy decoding are often required in a data encoding process. An objective of the entropy encoding is to estimate a quantity of bits required for encoding according to inputted feature data. The entropy encoding is generally implemented based on a statistical model, and the statistical model analyzes and models encoded data, to reduce the quantity of bits required as much as possible in an entropy encoding process. The entropy decoding is an inverse process of the entropy encoding. However, complexity of the entropy encoding and entropy decoding processes in the related art is high, resulting in low data encoding and decoding efficiency.

SUMMARY

According to various embodiments of this application, a data encoding method and apparatus, a computer device, a computer-readable storage medium, and a computer program product, and a data decoding method and apparatus, a computer device, a computer-readable storage medium, and a computer program product are provided.

According to an aspect, this application provides a data encoding method. The method includes:

obtaining a plurality of scale parameter quantization values by performing quantization processing on a scale parameter value corresponding to each of a plurality of feature elements in predetermined data, the scale parameter value defining a probability distribution corresponding to a respective one of the plurality of feature elements;

selecting, according to a preset selecting condition, a subset of scale parameter quantization values from the plurality of scale parameter quantization values; and

performing, for each feature element corresponding to a respective one of the subset of scale parameter quantization values, entropy encoding on the feature element based on the respective scale parameter quantization value, for determination of an encoded data stream of the feature data.

According to another aspect, this application further provides a data encoding apparatus. The apparatus includes:

a quantization value selecting module, configured to obtain a plurality of scale parameter quantization values by performing quantization processing on a scale parameter value corresponding to each of a plurality of feature elements in predetermined data, the scale parameter value defining a probability distribution corresponding to a respective one of the plurality of feature elements; and select, according to a preset selecting condition, a subset of scale parameter quantization values from the plurality of scale parameter quantization values; and

an entropy encoding module, configured to perform, for each feature element corresponding to a respective one of the subset of scale parameter quantization values, entropy encoding on the feature element based on the respective scale parameter quantization value, for determination of an encoded data stream of the feature data.

According to another aspect, this application further provides a computer device. The computer device includes a memory and a processor, the memory having computer-readable instructions stored therein, and when the processor executes the computer-readable instructions, the operations of the foregoing data encoding method are implemented.

According to another aspect, this application further provides a computer-readable storage medium. The computer-readable storage medium has computer-readable instructions stored therein, and the computer-readable instructions, when executed by a processor, implementing the operations of the foregoing data encoding method.

According to another aspect, this application further provides a computer program product. The computer program product includes computer-readable instructions, and the computer-readable instructions, when executed by a processor, implement the operations of the foregoing data encoding method.

According to another aspect, this application provides a data decoding method. The method includes:

obtaining a plurality of scale parameter quantization values by performing quantization processing on a scale parameter value corresponding to each of a plurality of feature elements in an encoded data stream of predetermined data, the scale parameter value defining a probability distribution corresponding to a respective one of the plurality of feature elements;

selecting, according to a preset selecting condition, a subset of scale parameter quantization values from the plurality of scale parameter quantization values; and

performing entropy decoding on the encoded data stream based on each selected scale parameter quantization value, for restoration of the feature data.

According to another aspect, this application further provides a data decoding apparatus. The apparatus includes:

a quantization value selecting module, configured to obtain a plurality of scale parameter quantization values by performing quantization processing on a scale parameter value corresponding to each of a plurality of feature elements in an encoded data stream of predetermined data, the scale parameter value defining a probability distribution corresponding to a respective one of the plurality of feature elements; and select, according to a preset selecting condition, a subset of scale parameter quantization values from the plurality of scale parameter quantization values; and

an entropy decoding module, configured to perform entropy decoding on the encoded data stream based on each selected scale parameter quantization value, for restoration of the feature data.

According to another aspect, this application further provides a computer device. The computer device includes a memory and a processor, where the memory has computer-readable instructions stored therein, and when the processor executes the computer-readable instructions, the operations of the foregoing data decoding method are implemented.

According to another aspect, this application further provides a computer-readable storage medium. The computer-readable storage medium has computer-readable instructions stored therein, and the computer-readable instructions, when executed by a processor, implementing the operations of the foregoing data decoding method.

According to another aspect, this application further provides a computer program product. The computer program product includes computer-readable instructions, and the computer-readable instructions, when executed by a processor, implementing the operations of the foregoing data decoding method.

BRIEF DESCRIPTION OF THE DRAWINGS

To describe the technical solutions in embodiments of this application or the conventional technology more clearly, the following briefly describes accompanying drawings required for describing the embodiments or the conventional technology. Apparently, the accompanying drawings in the following descriptions show merely the embodiments of this application, and a person of ordinary skill in the art may still derive other accompanying drawings from these accompanying drawings without creative efforts.

FIG. 1 is a diagram of an application environment of a data encoding method and a data decoding method according to some embodiments.

FIG. 2 is a schematic flowchart of a data encoding method according to some embodiments.

FIG. 3 is a schematic flowchart of a data encoding method according to some other embodiments.

FIG. 4 is a schematic flowchart of a data decoding method according to some other embodiments.

FIG. 5 is a schematic diagram of an overall process of video encoding and decoding according to some embodiments.

FIG. 6 is a framework diagram of an encoding and decoding model according to some embodiments.

FIG. 7 is a schematic flowchart of an entropy encoding module according to some embodiments.

FIG. 8 is a schematic flowchart of an encoding procedure of a first device according to some embodiments.

FIG. 9 is a schematic flowchart of a decoding procedure of a first device according to some embodiments.

FIG. 10 is a schematic flowchart of a decoding procedure of a first device according to some embodiments.

FIG. 11 is a schematic diagram of comparison results for different thresholds according to some embodiments.

FIG. 12 is a structural block diagram of a data encoding apparatus according to some embodiments.

FIG. 13 is a structural block diagram of a data decoding apparatus according to some embodiments.

FIG. 14 is a diagram of an internal structure of a computer device according to some embodiments.

FIG. 15 is a diagram of an internal structure of a computer device according to some embodiments.

DESCRIPTION OF EMBODIMENTS

The technical solutions in embodiments of this application are clearly and completely described below with reference to accompanying drawings in the embodiments of this application. Apparently, the described embodiments are merely some rather than all of the embodiments of this application. Based on the embodiments of this application, all other embodiments obtained by a person of ordinary skill in the art without creative efforts shall fall within the protection scope of this application.

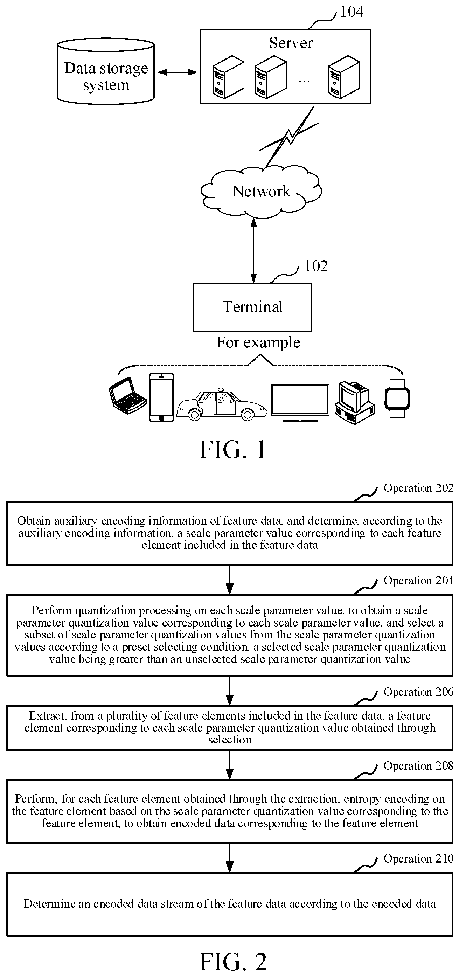

A data encoding method and a data decoding method provided in the embodiments of this application may be applicable to an application environment shown in FIG. 1. A terminal 102 communicates with a server 104 through a network. A data storage system may be separately set up, or may be integrated on the server 104, or may be placed on a cloud or another server. The server 104 may be an independent physical server, or may be a server cluster formed by a plurality of physical servers or a distributed system, or may be a cloud server that provides a basic cloud computing service such as a cloud service, a cloud database, cloud computing, a cloud function, cloud storage, a network service, cloud communication, a middleware service, a domain name service, a security service, a content delivery network (CDN), big data, and an artificial intelligence platform. The terminal 102 may be, but is not limited to, a desktop computer, a notebook computer, a smart phone, a tablet computer, an Internet of Things device, and a portable wearable device. The Internet of Things device may be a smart speaker, a smart television, a smart air condition, a smart in-vehicle device, or the like.

The data encoding method provided in the embodiments of this application may be performed by the first device. The first device may be the server 104 or the terminal 102 shown in FIG. 1. In an encoding process according to the embodiments of the application, the first device obtains a plurality of scale parameter quantization values by performing quantization processing on a scale parameter value corresponding to each of a plurality of feature elements in predetermined data, the scale parameter value defining a probability distribution corresponding to a respective one of the plurality of feature elements; selects, according to a preset selecting condition, a subset of scale parameter quantization values from the plurality of scale parameter quantization values; and performs, for each feature element corresponding to a respective one of the subset of scale parameter quantization values, entropy encoding on the feature element based on the respective scale parameter quantization value, for determination of an encoded data stream of the predetermined data

In some embodiments of the application, the first device may obtain auxiliary encoding information of predetermined data; determine, according to the auxiliary encoding information, a scale parameter value corresponding to each feature element included in the predetermined data; perform quantization processing on each scale parameter value, to obtain a scale parameter quantization value corresponding to each scale parameter value; select a subset of scale parameter quantization values from the scale parameter quantization values according to a preset selecting condition; extract, from a plurality of feature elements included in the feature data, a feature element corresponding to each scale parameter quantization value obtained through selection; perform, for each feature element obtained through the extraction, entropy encoding on the feature element based on the scale parameter quantization value corresponding to the feature element, to obtain encoded data corresponding to the feature element; and determine an encoded data stream of the predetermined data according to the encoded data.

The data decoding method provided in the embodiments of this application may be performed by a second device. The second device may be the server 104 or the terminal 102 shown in FIG. 1. In a decoding process, the second device obtains a plurality of scale parameter quantization values by performing quantization processing on a scale parameter value corresponding to each of a plurality of feature elements in an encoded data stream of predetermined data, the scale parameter value defining a probability distribution corresponding to a respective one of the plurality of feature elements; selects, according to a preset selecting condition, a subset of scale parameter quantization values from the plurality of scale parameter quantization values; and performs entropy decoding on the encoded data stream based on each selected scale parameter quantization value, for restoration of the predetermined data.

In some embodiments of the application, the second device may obtain auxiliary encoding information corresponding to an encoded data stream, the encoded data stream being obtained by encoding some feature elements of predetermined data according to the auxiliary encoding information. The second device further determines, according to the auxiliary encoding information, a scale parameter value corresponding to each feature element included in the predetermined data; perform quantization processing on each scale parameter value, to obtain a scale parameter quantization value corresponding to each scale parameter value; select, from the scale parameter quantization values, a subset of scale parameter quantization values according to a preset selecting condition, the selected scale parameter quantization value being greater than an unselected scale parameter quantization value; perform entropy decoding on the encoded data stream based on each selected scale parameter quantization value, to obtain a corresponding feature element; determine, according to each unselected scale parameter quantization value, a position of a feature element that forms the predetermined data and is not entropy-encoded (or alternatively, on which entropy encoding is not performed), and determine a replacement element at the position of the feature element that is not entropy-encoded; and combine the feature element obtained through entropy decoding and the replacement element, to obtain restored predetermined data.

In some embodiments, as shown in FIG. 2, a data encoding method is provided. The method is performed by a first device, and the first device may be the server 104 or the terminal 102 shown in FIG. 1. In the embodiments of this application, an example in which the method is applied to the server shown in FIG. 1 is used for description. It is noted herein that the technical features in the following embodiments described with reference to the drawings in this application can be implemented in their respective embodiments, or implemented in combination with features in any other embodiments. That is, the embodiments in the application each can be implemented alone, or in combination with any one or more of the other embodiments in the application, to achieve different technical solutions and technical effects. It is also noted that the embodiments described with reference to the drawings in this application are merely exemplary, and it is not limited in this application that the respective method must include all the steps/operations as described and illustrated; rather, the methods in the application each may include some or all of the steps as listed, and the steps may be combined with each other arbitrarily to form various embodiments of the application

In some embodiments of the application, the method may include operation 202: Obtain auxiliary encoding information of feature data, and determine, according to the auxiliary encoding information, a scale parameter value corresponding to each feature element included in the feature data.

That is, in some embodiments of the predetermined data may specifically be feature data containing a plurality of feature elements. The feature data is data obtained by pre-encoding original data. The original data may be video frame data or image data. For example, an original video frame, an original image, motion estimation data of a video frame, or residual compensation data of a video frame, and corresponding feature data is a feature map; the original data may alternatively be audio data, and corresponding feature data may be an audio feature variable; and the original data may alternatively be point cloud data, and corresponding feature data may be point cloud feature data. The pre-encoding includes processing such as transformation, quantization, and inverse transformation, and may be implemented based on a conventional mathematical manner, or may be implemented based on a deep learning neural network. The auxiliary encoding information is information configured for assisting in an encoding process, that is, side information. The side information may be feature information obtained by further encoding the feature data, for example, may be feature information obtained by inputting the feature data into a neural network for further extraction. However, the predetermine data is not limited to feature data as described above in the present application; rather, the predetermined data can be various other types of data, for example but not limited to the original data as indicated above. A quantity of feature elements included in the side information is less than that of feature elements of the feature data. For example, using an example in which the feature data is the feature map, hyperprior encoding may be performed, by using a video encoding and decoding model, on the feature map for reducing a feature dimension, to obtain auxiliary encoding information of the feature map. Further, the auxiliary encoding information may be inputted into an entropy model in the video encoding and decoding model, and a scale parameter value and a position parameter value that correspond to each feature element included in the feature data are outputted by using the entropy model. The video encoding and decoding model may include a variational autoencoder (VAE) model, the entropy model corresponds to a prior of a VAE hidden layer representation, and the auxiliary encoding information is configured for assisting in entropy model encoding, that is, a prior of the prior, and therefore is referred to as hyperprior encoding.

The feature data includes feature elements. The feature elements are data units forming the feature data. Using an example in which the feature data is the feature map, the feature element is a pixel of the feature map, and each pixel represents one feature element.

The scale parameter value corresponding to the feature element is a parameter value defining a probability distribution corresponding to the feature element. The probability distribution parameter value corresponding to the feature element is a related parameter value of a probability distribution function corresponding to the feature element. The probability distribution function corresponding to the feature element is a function configured for describing a probability distribution of the feature element. The probability distribution of the feature element is a distribution situation of a probability that the feature element takes a series of possible values relative to these values. In some embodiments, a probability of a value of the feature element may reflect a probability that the value appears in the feature map.

The related parameter value of the probability distribution function includes a scale parameter value and a position parameter value. The scale parameter value determines a shape, for example, a degree of flatness, of a curve describing the probability distribution function. A greater scale parameter value indicates a flatter curve of the probability distribution function. Conversely, a less scale parameter value indicates a thinner and taller curve of the probability distribution function. A horizontal coordinate of the curve of the probability distribution function is the value of the feature element, and a vertical coordinate of the curve of the probability distribution function is a probability value. Therefore, a greater scale parameter value indicates a higher degree of discretization of probability distribution. During application, the probability distribution of the feature element may be Gaussian distribution or Laplace distribution. When the probability distribution of the feature element is Gaussian distribution, a scale parameter may in some embodiments be a variance or a standard deviation of the probability distribution. The variance of the probability distribution may be a mean of a quadratic sum of differences between each probability value and a mean of all probability values in the probability distribution, and the standard deviation is an arithmetic square root of the variance. The position parameter value is configured for describing a central tendency position of the probability distribution. When the probability distribution of the feature element is Gaussian distribution, a position parameter may in some embodiments be a mean of the probability distribution of the feature element, or a mathematical expectation. In the embodiments of this application, the position parameter value of the feature element may be determined as a prediction feature value of the feature element.

The scale parameter value of the feature element may further represent a degree of deviation of the feature element relative to an overall distribution of the feature data, and the scale parameter value may be positively correlated with the degree of deviation. That is, a greater scale parameter value indicates a greater degree of deviation of the feature element relative to the overall distribution of the feature data. This is because a greater scale parameter value indicates a greater degree of discretization of the probability distribution, and a greater range of the value of the feature element indicates a greater degree of certainty of the value of the feature element. Therefore, the scale parameter value is more capable of reflecting the degree of certainty of the value of the feature element. However, in a data encoding process, there is generally more redundant information between two frames of to-be-encoded original data. The redundant information generally presents aggregation in original data. The redundant information carries a small amount of information, and can be accurately predicted in an encoding and decoding process, with high certainty. Correspondingly, a feature element corresponding to the redundant information also presents aggregation in feature data. A greater degree of deviation of a feature element relative to the overall distribution of the feature data indicates lower certainty of the feature element, that is, a greater scale parameter value of the feature element. Therefore, the degree of deviation of the feature element relative to the overall distribution of the feature data may be represented by using the scale parameter value of the feature element.

In some embodiments, the server may obtain the feature data, perform hyperprior encoding on the feature data for reducing a feature dimension, to obtain the auxiliary encoding information of the feature data, and then determine, according to the auxiliary encoding information, the scale parameter value corresponding to each feature element included in the feature data.

For example, when the to-be-encoded original data is the video frame, the data encoding method in this application may be implemented by using the video encoding and decoding model. The video encoding and decoding model includes the entropy model. The entropy model is a model configured for predicting data required for an entropy encoding process. The probability distribution parameter value corresponding to each feature element in the feature map may be predicted by using the entropy model.

In some embodiments of the application, the method may further include operation 204: perform quantization processing on each scale parameter value, to obtain a scale parameter quantization value corresponding to each scale parameter value, and select a subset of scale parameter quantization values from the scale parameter quantization values according to a preset selecting condition, a selected scale parameter quantization value being greater than an unselected scale parameter quantization value.

The quantization processing is a process of performing discretization on the scale parameter value. The scale parameter value determined according to the auxiliary encoding information is a floating point number. The floating point number is a value in a continuous interval, and has uncertainty in different computing environments. Therefore, quantization processing needs to be performed on the scale parameter value. For example, quantization processing may be a process of representing the scale parameter value by using an integer. In some embodiments, the scale parameter quantization values as obtained by the quantization processing are respectively corresponding to the feature elements in the feature data, since each of the scale parameter quantization values is obtained by quantization processing on the scale parameter value corresponding to each feature element in the feature data.

The preset selecting condition is a condition that may be configured for selecting a larger value from the scale parameter quantization values obtained through quantization processing, and may in some embodiments be set according to needs. In some embodiments, the preset selecting condition may be that a scale parameter quantization value exceeds a preset quantization threshold. In some embodiments, the preset selecting condition may further be that the scale parameter quantization values are required to be ranked in the first N when sorted in ascending order. In some embodiments, the preset selecting condition may alternatively be that the scale parameter quantization value is required to be data whose value is a maximum N% in all scale parameter quantization values. The selected scale parameter quantization value is greater than the unselected scale parameter quantization value, and the scale parameter quantization value may be positively correlated with the represented degree of deviation. That is, the selected scale parameter quantization value may have a greater degree of deviation than the unselected scale parameter quantization value.

In some embodiments, the server may determine a quantization stepsize, and perform quantization processing on each scale parameter value according to the quantization stepsize, to obtain a scale parameter quantization value corresponding to each scale parameter value.

It is considered that, in the encoding process, the large amount of redundant information exists between data frames. Therefore, most feature elements are in aggregated distribution in the overall distribution of the feature data. If the degree of deviation of a feature element is small, the feature element has high certainty and is probably redundant information. Because the redundant information can be accurately predicted in the encoding process, encoding and decoding of this element may be skipped in the encoding process, thereby greatly accelerating entropy encoding and entropy decoding stages without affecting encoding and decoding quality, and improving encoding and decoding efficiency. The scale parameter quantization value is obtained by performing quantization processing on the scale parameter value, and may also represent the degree of certainty of the feature element. Therefore, the server may select a subset of scale parameter quantization values with large values from the scale parameter quantization values according to the preset selecting condition, so as to expect, in the entropy encoding process, to select a feature element corresponding to non-redundant information for entropy encoding according to the scale parameter quantization values, and skip entropy encoding for the feature element of the redundant information.

In some embodiments, when the feature data is obtained by pre-encoding motion compensation data, the server may further perform secondary selection on unselected scale parameter quantization values. In the secondary selection, the server may further obtain motion estimation data of a data frame to which the feature data belongs, determine, according to the motion estimation data, a motion estimation value matching a position of a feature element corresponding to each scale parameter quantization value in the unselected scale parameter quantization values, and further select, from the unselected scale parameter quantization values, a scale parameter quantization value whose matching motion estimation value is greater than a motion estimation threshold.

In some embodiments, each scale parameter value is a floating point number, and/or each scale parameter quantization value is an integer. The first device maps a continuous floating point number to a discrete integer in a quantization process, so that when performing quantization in a same manner, the second device may obtain a same scale parameter quantization value. The second device may further obtain the scale parameter quantization value by selecting in a same selecting manner as that of the first device, so that the first device and the second device may perform entropy encoding and entropy decoding on a same feature element, thereby avoiding a situation in which calculation results of the scale parameter value are inconsistent across devices when in an encoding process and a decoding process, resulting in inaccurate reconstructed data obtained through decoding.

In some embodiments of the application, the method may further include operation 206: Extract, from a plurality of feature elements included in the feature data, a feature element corresponding to each scale parameter quantization value obtained through selection.

A correspondence between the scale parameter quantization value and the feature element is a position correspondence. Using an example in which the feature data is the feature map, a scale parameter quantization value obtained by performing quantization on a scale parameter value determined for the feature data may be a map having a same dimension as the feature map. Therefore, for each scale parameter quantization value in the map having the same dimension, a feature element at a same position in the feature map is a feature element corresponding to the scale parameter quantization value.

In some embodiments, the server may extract, from the plurality of feature elements included in the feature data, a feature element corresponding to each scale parameter quantization value obtained through selection. Because there are only some selected scale parameter quantization values, the selected feature elements also include only some feature elements of the feature data. In a next entropy encoding process, the server performs entropy encoding on only the selected feature elements, and skips entropy encoding on the unselected feature elements. In some embodiments, each feature element corresponding to a respective one of the subset of scale parameter quantization values is obtained by the above extraction.

In some embodiments of the application, the method may further include operation 208: Perform, for each feature element obtained through the extraction, entropy encoding on the feature element based on the scale parameter quantization value corresponding to the feature element, to obtain encoded data corresponding to the feature element.

In some embodiments, for each feature element corresponding to a respective one of the subset of scale parameter quantization values, entropy encoding on the feature element is performed based on the respective scale parameter quantization value, for determination of an encoded data stream of the feature data. Each feature element corresponding to a respective one of the subset of scale parameter quantization values may be determined by the extraction operation in 206.

In some embodiments, because quantization processing is performed on the original scale parameter value, when performing entropy encoding, for each selected feature element, the server may re-determine a scale parameter value of the feature element based on a scale parameter quantization value corresponding to the selected feature element, and may determine a probability distribution function required for entropy encoding according to the re-determined scale parameter value, so that the feature map may be compressed into a byte stream as few as possible by using the probability distribution function. The entropy encoding may be implemented by using arithmetic coding or range coding. The arithmetic coding is used as an example, after a probability distribution function required for the arithmetic coding is obtained, a probability value of each feature element in the feature map may be calculated, then the feature elements are read in one by one. Each time a feature element is read in, a range of the feature map on [0, 1] is reduced to a latest obtained interval according to a ratio, a value of the ratio is determined by the probability value of each feature element, and then iteration is performed in sequence until all feature elements are completely read, and any decimal in the obtained interval is outputted in a binary form to obtain the encoded data stream. In some embodiments, during application, re-determining the scale parameter value according to the scale parameter quantization value may be implemented by using formula (1), where $scale_{QS}$ is a quantization stepsize, $scale_{max}$ is a maximum value of a scale parameter value, and may in some embodiments be 64.0, $scale_{min}$ is a minimum value of a scale parameter value, and may in some embodiments be 0.11, L is a maximum quantization level, and may in some embodiments be 256, *index* is a scale parameter quantization value, and in a value range of 0 to 255, and *scale_q* represents a re-determined scale parameter value.

$$scale\_q = \exp\left(\log\left(scale_{min}\right) + scale_{QS} \times index\right) \qquad \text{Formula (1)}$$

In some embodiments, the server may further construct a mapping relationship between a scale parameter quantization value index and *scale_q* by using the foregoing formula (1), to construct a probability distribution function lookup table, for example: *index*=0 corresponds to scale_q=0.1100 and *index*=1 corresponds to scale_q=0.1128. Therefore, after the scale parameter quantization value is selected, the scale parameter value *scale_q* may be directly searched in a mapping relationship table, thereby improving arithmetic coding efficiency.

In some embodiments, after obtaining the scale parameter value *scale_q* corresponding to a feature element, the server may determine a probability distribution function required for arithmetic coding according to the scale parameter value *scale_q* corresponding to the feature element and the position parameter, to determine that a probability value of the feature element may be a probability value calculated by substituting a value of the feature element into the probability distribution function. Further, in some embodiments, the server may subtract a corresponding position parameter value from a value at each feature element position in a feature map y, and a subtracted feature map y_0 may be considered as a mean distribution of 0, so that the server may search a pre-established probability value lookup table according to the value of each feature element in the feature map y_0 with the mean distribution of 0, to obtain a probability value. The pre-established probability value lookup table is established in the following manner: Under a probability distribution function determined by each scale parameter value *scale_q* and the mean 0, a probability value of each possible value of the feature element is calculated, and a correspondence between the possible value of the feature element and the calculated probability value under each probability distribution function is established.

In some embodiments of the application, the method may further include operation 210: Determine an encoded data stream of the feature data according to the encoded data.

In some embodiments, the server may directly use the obtained encoded data as the encoded data stream of the feature data, or further process the encoded data and use the further processed feature data as the encoded data stream of the feature data.

During application, the server may send the encoded data stream to the second device, and the second device may decode based on the encoded data stream, to reconstruct a data frame to which the feature data belongs. In some embodiments, the server may encode the auxiliary encoding information into the encoded data stream of the feature data, and send the encoded data stream to the second device together.

In the foregoing data encoding method, the auxiliary encoding information of the feature data is obtained; the scale parameter value corresponding to each feature element included in the feature data is determined according to the auxiliary encoding information; quantization processing is performed on each scale parameter value; a subset of scale parameter quantization values are selected from the scale parameter quantization values obtained through quantization processing according to the preset selecting condition, the selected scale parameter quantization value being greater than the unselected scale parameter quantization value; the feature element corresponding to each scale parameter quantization value obtained through selection is extracted from the plurality of feature elements included in the feature data; and for each feature element obtained through the extraction, entropy encoding is performed on the feature element based on the scale parameter quantization value corresponding to the feature element, to obtain the encoded data corresponding to the feature element, so that the encoded data stream of the feature data can be determined according to the encoded data. In the entropy encoding process, the scale parameter quantization value may be selected according to the preset selecting condition, the feature element is selected according to a selected scale parameter quantization value, entropy encoding is performed on only the selected feature element, and the entropy encoding process of the unselected feature element is skipped. Therefore, the quantity of feature elements on which entropy encoding needs to be performed can be significantly reduced, thereby greatly reducing complexity of entropy encoding, and significantly improving data encoding efficiency.

In some embodiments, the selecting a subset of scale parameter quantization values from the scale parameter quantization values according to a preset selecting condition includes: comparing each scale parameter quantization value obtained through quantization processing with the preset quantization threshold, to obtain a comparison result corresponding to each scale parameter quantization value; and selecting, from the scale parameter quantization values, a scale parameter quantization value whose corresponding comparison result indicates that the scale parameter quantization value exceeds the preset quantization threshold, to obtain a subset of scale parameter quantization values.

In some embodiments, the preset selecting condition is that the scale parameter quantization value exceeds the preset quantization threshold. The preset quantization threshold may be set and adjusted according to needs. A greater preset quantization threshold indicates more feature elements to be skipped in the entropy encoding process, a better acceleration effect in the entropy encoding stage indicates more prominent improvement in encoding efficiency. Definitely, different preset quantization thresholds also have some impact on a reconstruction effect in the decoding process. Therefore, balance may be performed according to actual needs.

In some embodiments, in a process of selecting the scale parameter quantization value, the server may compare each scale parameter quantization value obtained through quantization processing with the preset quantization threshold, to obtain the comparison result corresponding to each scale parameter quantization value. If a comparison result of a scale parameter quantization value indicates that the scale parameter quantization value exceeds the preset quantization threshold, the scale parameter quantization value is selected, or if a comparison result of a scale parameter quantization value indicates that the scale parameter quantization value does not exceed the preset quantization threshold, the scale parameter quantization value is filtered out. Finally, a subset of scale parameter quantization values can be selected, and the scale parameter quantization values are greater than the unselected scale parameter quantization values.

In some embodiments, each scale parameter quantization value obtained through quantization processing is compared with the preset quantization threshold, and the scale parameter quantization value whose comparison result indicates that the scale parameter quantization value exceeds the preset quantization threshold is selected from the scale parameter quantization values, so that the scale parameter quantization value may be quickly selected, thereby improving selecting efficiency and improving encoding efficiency.

In some embodiments, the extracting, from a plurality of feature elements included in the feature data, a feature element corresponding to each scale parameter quantization value obtained through selection includes, or, each feature element corresponding to a respective one of the subset of scale parameter quantization values is determined by: determining a motion estimation value corresponding to each scale parameter quantization value in the subset of scale parameter quantization values, the motion estimation value matching a position of a feature element corresponding to a respective scale parameter quantization value of the motion estimation value; selecting, from the subset of scale parameter quantization values, a scale parameter quantization value whose corresponding motion estimation value is greater than a motion estimation threshold; and extracting, from the plurality of feature elements included in the feature data, a feature element corresponding to each selected scale parameter quantization value corresponding to a motion estimation value greater than the motion estimation threshold.

In some embodiments, the feature data is a feature map corresponding to the video frame data, the motion estimation data is a motion vector map obtained by performing motion estimation, and a motion estimation value of the motion estimation data may represent an amplitude of motion between video frames. Generally, a pixel at a position with a large motion estimation value includes important information, and the pixel at the position with the large motion estimation value is generally redundant information. Based on this, in some embodiments, secondary selection may be further performed on a subset of scale parameter quantization values obtained through selection based on the motion estimation value.

In some embodiments, the vector map obtained through motion estimation is the same as an original dimension of the video frame, and feature data is equivalent to a feature map after feature extraction is performed, and is smaller than a motion estimation map in dimension. Therefore, during actual application, the vector map obtained through motion estimation generally needs to be reduced in dimension, to make the vector map be the same as the feature map in dimension, so that a motion estimation value matching a position of a feature element corresponding to each scale parameter quantization value in some selected scale parameter quantization values may be determined in the vector map obtained through dimension reduction. In the vector map obtained through motion estimation, each position has two values, and are respectively an x value in a horizontal direction and a y value in a vertical direction. The motion estimation value may be a statistical value of values in the two directions. For example, an x value and a y value at each position may be added, to obtain a motion estimation value of the position. Because a dimension of the vector map obtained through motion estimation is the same as that of the feature map, for each pixel in the feature map, a motion estimation value at a same position in the vector map is a motion estimation value matching the position. The server may continue to select, from a subset of scale parameter quantization values obtained through first selection, a scale parameter quantization value whose matching motion estimation value is greater than the motion estimation threshold. Further, the server may select, from the plurality of feature elements included in the feature map, a feature element corresponding to each scale parameter quantization value obtained through secondary selection.

In a video encoding process, original data may be a video frame used as a reference frame, a vector map obtained through motion estimation, and motion compensation data. Only for entropy encoding of the motion compensation data, secondary selection can be performed by using the method provided in this embodiment.

In the foregoing embodiment, because secondary selection may be performed by using the motion estimation value in the motion estimation data, to avoid that the feature element corresponding to the redundant information is selected in a first selection process, more feature elements may be skipped in the entropy encoding process, thereby further reducing complexity of entropy encoding.

In some embodiments, the performing quantization processing on each scale parameter value includes: determining a quantization stepsize, the quantization stepsize being positively correlated with a difference between a maximum value and a minimum value of the scale parameter value, and the quantization stepsize being negatively correlated with a maximum quantization level set for quantization processing; determining a difference between each scale parameter value and a minimum value of the scale parameter value; and performing a rounding operation on the quantization stepsize according to the difference corresponding to each scale parameter value, to obtain the scale parameter quantization value corresponding to each scale parameter value.

In some embodiments, the quantization stepsize may be calculated by using the following formula (2), where $scale_{QS}$ is a quantization stepsize.

$$scale_{QS} = \frac{\log(scale_{max}) - \log(scale_{min})}{L - 1} \qquad \text{Formula (2)}$$

The scale parameter quantization value may be calculated by using the following formula (3), where index is a scale parameter quantization value, and is an integer in a value range of 0 to 255.

$$\text{index} = \left\lfloor \frac{\log(scale) - \log(scale_{min})}{scale_{QS}} \right\rfloor \qquad \text{Formula (3)}$$

Formula (3) represents performing rounding, that is, near rounding on $\frac{\log(scale) - \log(scale_{min})}{scale_{QS}}$. In some other embodiments, rounding up or rounding down may also be performed on $\frac{\log(scale) - \log(scale_{min})}{scale_{QS}}$. Rounding up may be rounding up to a nearest integer value, rounding down may be rounding down to a nearest integer value, and near rounding may be rounding to a nearest integer value in a rounding manner. For example, a value obtained by performing rounding up on 71.97 may be 72, a value obtained by performing rounding down on 71.97 may be 71, and a value obtained by performing near rounding on 71.97 may be 72.

In some embodiments, the quantization stepsize is determined, the difference between each scale parameter value and the minimum value is determined, and a rounding operation is performed on the quantization stepsize according to the difference corresponding to each scale parameter value, to obtain the scale parameter quantization value corresponding to each scale parameter value, so that each scale parameter value can be quantized more accurately.

In some embodiments, the feature data is a feature map; and the data encoding method in this application further includes: determining, from the plurality of feature elements included in the feature map, a feature element corresponding to each unselected scale parameter quantization value; performing, according to a position of the feature element corresponding to each unselected scale parameter quantization value in the feature map, region division on feature elements corresponding to unselected scale parameter quantization values, to obtain a plurality of feature element regions; selecting, for each of the plurality of feature element regions, at least one feature element located at a central position of the feature element region as a representative feature element of the feature element region; and performing entropy encoding on a representative feature element based on a scale parameter quantization value of the representative feature element, to obtain additional encoded data of the feature data. As can be understood, there may be a plurality of unselected scale parameter quantization values corresponding to a subset of feature elements from all the feature elements in the feature map, and the subset of feature elements may be divided, according to positions of the subset of feature elements in the feature map, into a plurality of feature element regions each containing at least one of feature element.

The representative feature element is a feature element configured for representing other elements in a region. There may be one or more representative feature elements, and more means at least two.

In some embodiments, it is considered that redundant information between video frames generally has a certain degree of aggregation, that is, the feature element corresponding to each unselected scale parameter quantization value is aggregated in a specific region of the feature map. Therefore, in the encoding process, region division may be performed on the feature elements corresponding to the unselected scale parameter quantization values. A division process may in some embodiments be: dividing feature elements whose distance between feature elements is less than a preset threshold into a region; for each divided feature element region, selecting at least one feature element located at a central position of the feature element region as the representative feature element; performing entropy encoding on the representative feature element based on the scale parameter quantization value of the representative feature element, to obtain the additional encoded data of the feature data. Further, the additional encoded data may be encoded into the encoded data stream of the feature data, and participate in the decoding procedure together with the encoded data stream.

In the foregoing embodiment, entropy encoding is performed on the representative feature element by selecting the representative feature element, so that more information can be encoded into the encoded data stream as much as possible when it is ensured that entropy encoding for some feature elements is skipped, to further ensure accuracy of an image obtained through decoding and reconstruction.

In some embodiments, the obtaining auxiliary encoding information of feature data, and determining, according to the auxiliary encoding information, a scale parameter value corresponding to each feature element included in the feature data includes: obtaining the feature data, and performing hyperprior encoding on the feature data for reducing a feature dimension, to obtain the auxiliary encoding information of the feature data; predicting, by using the auxiliary encoding information, a probability distribution parameter value of each feature element included in the feature data, to obtain the scale parameter value corresponding to each feature element.

In some embodiments, the entropy encoding process may be implemented by using an AI model. During application, the AI model herein may be a variational autoencoder (VAE) model, where the entropy model is a prior of a VAE hidden layer representation, and the auxiliary encoding information is configured for assisting in entropy model encoding, that is, a prior of the prior, and therefore is referred to as hyperprior encoding.

In some embodiments, after obtaining the feature data, the server may input the feature data into a neural network, perform hyperprior encoding for reducing a feature dimension by using the neural network, to obtain the auxiliary encoding information of the feature data, input the auxiliary encoding information as a prior parameter into the entropy model, and estimate a probability distribution of each feature element by using the entropy model. A process of estimating the probability distribution is equivalent to performing hyperprior decoding, to obtain the scale parameter value corresponding to each feature element included in the feature data and the prediction feature value corresponding to each feature element, where the scale parameter value may in some embodiments be a variance of the probability distribution function of the feature element, and the prediction feature value may in some embodiments be a mean of the probability distribution function of the feature element.

In the foregoing embodiment, the auxiliary encoding information is obtained through hyperprior encoding, and the probability distribution of each feature element is estimated by using the auxiliary encoding information to obtain the scale parameter value, so that spatial correlation of the hidden layer representation can be captured, and the obtained scale parameter value is more accurate.

In some embodiments, the feature data corresponds to a current data frame; and the method further includes: obtaining an encoded data stream of a previous data frame, and reconstructing the previous data frame based on the encoded data stream of the previous data frame; performing motion estimation on the current data frame based on the reconstructed previous data frame, to obtain motion estimation data of the current data frame; performing residual compensation estimation on the current data frame based on the motion estimation data, to obtain residual compensation data of the current data frame; and determining the motion estimation data and the residual compensation data as the feature data corresponding to the current data frame.

The encoded data stream of the previous data frame is obtained by encoding the feature data of the previous data frame. In some embodiments, the method may include: obtaining auxiliary encoding information of the feature data of the previous data frame, and determining, according to the auxiliary encoding information, a scale parameter value corresponding to each feature element included in the feature data; performing quantization processing on each scale parameter value, and selecting, according to a preset selecting condition, a subset of scale parameter quantization values from the scale parameter quantization values obtained through quantization processing, a selected scale parameter quantization value being greater than an unselected scale parameter quantization value; extracting, from a plurality of feature elements included in the feature data, a feature element corresponding to each scale parameter quantization value obtained through selection; performing, for each feature element obtained through the extraction, entropy encoding on the feature element based on the scale parameter quantization value corresponding to the feature element, to obtain encoded data corresponding to the feature element; and determining the encoded data stream of the previous data frame based on the encoded data.

In some embodiments, when the current data frame needs to be encoded, the server may obtain the encoded data stream of the previous data frame, reconstruct the previous data frame based on the encoded data stream of the previous data frame, perform motion estimation on the current data frame based on the reconstructed previous data frame, to obtain motion estimation data of the current data frame, and perform residual compensation estimation on the current data frame based on the motion estimation data, to obtain residual compensation data of the current data frame, the obtained motion estimation data and residual compensation data being original data corresponding to the current data frame. The server may pre-encode the original data to obtain the feature data. After obtaining the feature data, the server may perform entropy encoding by performing the operations in the foregoing embodiment, to obtain the encoded data stream of the current data frame.

In the foregoing embodiment, the encoded data stream of the previous data frame is obtained, the previous data frame is obtained through decoding and reconstruction based on the encoded data stream of the previous data frame, and the current data frame is encoded based on the reconstructed data frame, which can effectively ensure that data decoded and reconstructed by the second device is consistent with the first device.

In some embodiments, the reconstructing the previous data frame based on the encoded data stream of the previous data frame includes: performing entropy decoding on the encoded data stream of the previous data frame based on a scale parameter quantization value selected in a process of encoding feature data of the previous data frame, to obtain a corresponding feature element; determining a replacement element at a position of a feature element that forms feature data of the previous data frame and is not entropy-encoded; combining the feature element obtained through entropy decoding and the replacement element, to obtain feature data restored for the previous data frame; and performing data reconstruction based on the feature data restored for the previous data frame, to obtain a reconstructed previous data frame.

In some embodiments, in a process of encoding the previous data frame, the server may select a subset of scale parameter quantization values, and further perform entropy encoding on only feature elements corresponding to the a subset of scale parameter quantization values. The server may further store the selected scale parameter quantization values and the unselected scale parameter quantization values. In a process of decoding and reconstructing the previous data frame, to ensure accuracy of a reconstruction result, the first device may determine, based on the scale parameter quantization value stored in the process of encoding the previous data frame, a distribution function required for entropy decoding, and further perform entropy decoding based on the determined distribution function, to obtain a corresponding feature element. The obtained feature element is data for restoring the feature element encoded in the entropy encoding process. A feature element that has not been encoded in the entropy encoding process cannot be obtained through entropy decoding in the decoding process. Therefore, in the decoding process, the server may determine, according to a position corresponding to the unselected scale parameter quantization value, the replacement element at a position of the feature element that forms the feature data and is not entropy-encoded, then combine the feature element obtained through entropy decoding and the replacement element, to obtain the feature data restored for the previous data frame, and finally perform data reconstruction based on the restored feature data of the previous data frame, to obtain the reconstructed previous data frame. The data reconstruction herein is an inverse process of the foregoing pre-encoding.

In the foregoing embodiment, the first device performs entropy decoding on the encoded data stream of the previous data frame by using the scale parameter quantization value selected in the process of encoding the feature data of the previous data frame, to obtain the corresponding feature element, thereby ensuring that entropy encoding and entropy decoding are performed on a same feature element in the encoding process and the decoding process, and ensuring accuracy of the decoded and reconstructed previous data frame.

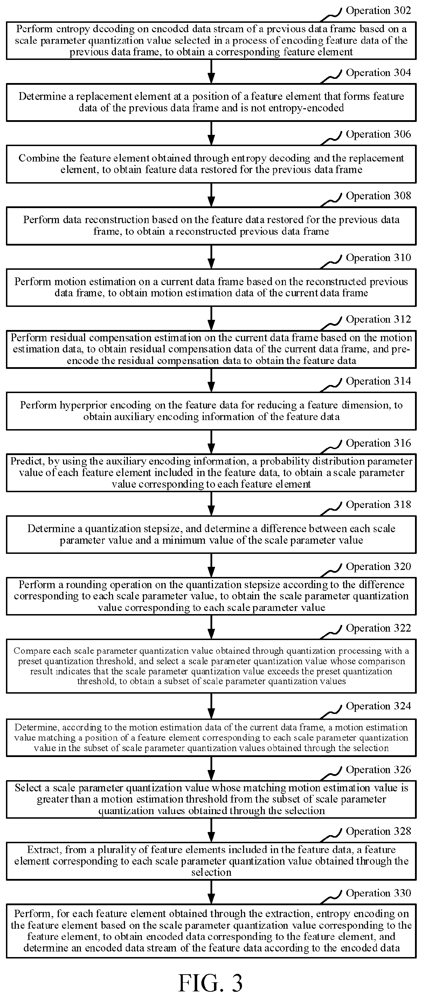

In some embodiments, as shown in FIG. 3, a data encoding method is provided. The method is performed by a first device, and the first device may be the server 104 or the terminal 102 shown in FIG. 1. In the embodiments of this application, an example in which the method is applied to the server shown in FIG. 1 is used for description.

In some embodiments of the application, the method may include operation 302: Perform entropy decoding on an encoded data stream of a previous data frame based on a scale parameter quantization value selected in a process of encoding feature data of the previous data frame, to obtain a corresponding feature element.

In some embodiments of the application, the method may further include operation 304: Determine a replacement element at a position of a feature element that forms feature data of the previous data frame and is not entropy-encoded.

In some embodiments of the application, the method may further include operation 306: Combine the feature element obtained through entropy decoding and the replacement element, to obtain feature data restored for the previous data frame.

In some embodiments of the application, the method may further include operation 308: Perform data reconstruction based on the feature data restored for the previous data frame, to obtain a reconstructed previous data frame.

In some embodiments of the application, the method may further include operation 310: Perform motion estimation on a current data frame based on the reconstructed previous data frame, to obtain motion estimation data of the current data frame.

In some embodiments of the application, the method may further include operation 312: Perform residual compensation estimation on the current data frame based on the motion estimation data, to obtain residual compensation data of the current data frame, and pre-encode the residual compensation data to obtain the feature data.

In some embodiments of the application, the method may further include operation 314: Perform hyperprior encoding on the feature data for reducing a feature dimension, to obtain auxiliary encoding information of the feature data.

In some embodiments of the application, the method may further include operation 316: Predict, by using the auxiliary encoding information, a probability distribution parameter value of each feature element included in the feature data, to obtain a scale parameter value corresponding to each feature element.

In some embodiments of the application, the method may further include operation 318: Determine a quantization stepsize, and determine a difference between each scale parameter value and a minimum value of the scale parameter value.

The quantization stepsize is positively correlated with a difference between a maximum value and a minimum value of the scale parameter value, and the quantization stepsize is negatively correlated with a maximum quantization level set for quantization processing.

In some embodiments of the application, the method may further include operation 320: perform a rounding operation on the quantization stepsize according to the difference corresponding to each scale parameter value, to obtain a scale parameter quantization value corresponding to each scale parameter value.

In some embodiments of the application, the method may further include operation 322: compare each scale parameter quantization value obtained through quantization processing with a preset quantization threshold, and select a scale parameter quantization value whose comparison result indicates that the scale parameter quantization value exceeds the preset quantization threshold, to obtain a subset of scale parameter quantization values.

In some embodiments of the application, the method may further include operation 324: Determine, according to the motion estimation data of the current data frame, a motion estimation value matching a position of a feature element corresponding to each scale parameter quantization value in the subset of scale parameter quantization values obtained through the selection.

In some embodiments of the application, the method may further include operation 326: Select a scale parameter quantization value whose matching motion estimation value is greater than a motion estimation threshold from a subset of scale parameter quantization values obtained through the selection.

In some embodiments of the application, the method may further include operation 328: Extract, from a plurality of feature elements included in the feature data, a feature element corresponding to each scale parameter quantization value obtained through the selection.

In some embodiments of the application, the method may further include operation 330: Perform, for each feature element obtained through the extraction, entropy encoding on the feature element based on the scale parameter quantization value corresponding to the feature element, to obtain encoded data corresponding to the feature element, and determine an encoded data stream of the feature data according to the encoded data.

During actual application, the server also needs to pre-encode the motion estimation data to obtain the feature data. After obtaining the feature data corresponding to the motion estimation data, the server may further select to obtain the scale parameter quantization value through operation 314 to operation 322, and then obtain the encoded data stream through operation 328 to operation 330.

In the foregoing embodiment, in the entropy encoding process, the scale parameter quantization value may be selected according to the preset selecting condition, the feature element is selected according to a selected scale parameter quantization value, entropy encoding is performed on only the selected feature element, and the entropy encoding process of the unselected feature element is skipped. Therefore, the quantity of feature elements on which entropy encoding needs to be performed can be significantly reduced, thereby greatly reducing complexity of entropy encoding, and significantly improving data encoding efficiency.

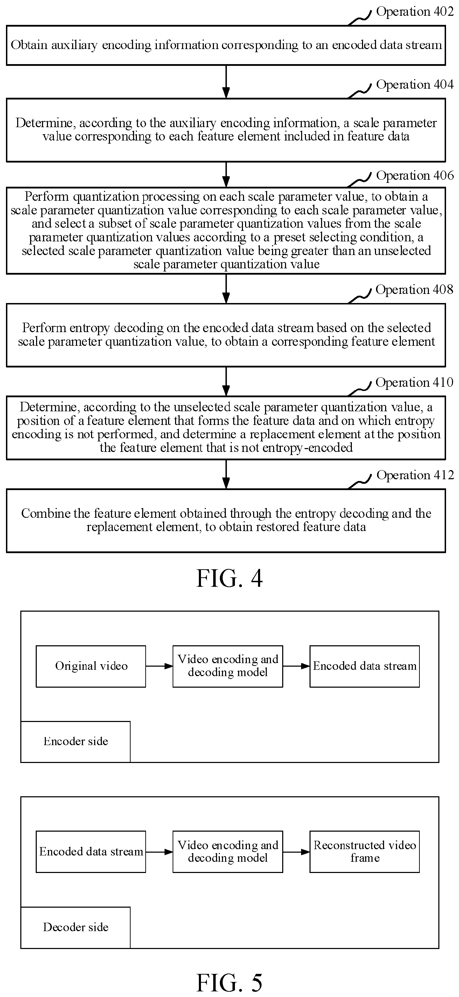

In some embodiments, as shown in FIG. 4, a data decoding method is provided. The method is performed by a second device, and the second device may be the server 104 or the terminal 102 shown in FIG. 1. In the embodiments of this application, an example in which the method is applied to the terminal shown in FIG. 1 is used for description.

In some embodiments, the method may include operation 402: Obtain auxiliary encoding information corresponding to an encoded data stream.

The auxiliary encoding information is information configured for assisting in an encoding process, that is, side information. The side information may be feature information obtained by further encoding the feature data, for example, may be feature information obtained by inputting the feature data into a neural network for further extraction. A quantity of feature elements included in the side information is less than that of feature elements of the feature data. The encoded data stream is obtained by encoding some feature elements of feature data according to the auxiliary encoding information. For an encoding process, refer to the foregoing embodiment, and details are not described herein again.

In some embodiments, the first device may encode the auxiliary encoding information into the encoded data stream in the encoding process, so that the terminal may obtain the auxiliary encoding information from the received encoded data stream after receiving the encoded data stream, and may further implement data decoding by using the auxiliary encoding information.

In some embodiments of the application, the method may further include operation 404: Determine, according to the auxiliary encoding information, a scale parameter value corresponding to each feature element included in feature data.

In some embodiments, the terminal may estimate, by using the auxiliary encoding information, a probability distribution parameter value of each feature element included in the feature data, to obtain a scale parameter value corresponding to each feature element, and may further obtain a prediction feature value corresponding to each feature element.

In some embodiments of the application, the method may further include operation 406: perform quantization processing on each scale parameter value, to obtain a scale parameter quantization value corresponding to each scale parameter value, and select a subset of scale parameter quantization values from the scale parameter quantization values according to a preset selecting condition, a selected scale parameter quantization value being greater than an unselected scale parameter quantization value.

The quantization processing is a process of performing discretization on the scale parameter value. The scale parameter value determined according to the auxiliary encoding information is a floating point number. The floating point number is a value in a continuous interval, and has uncertainty in different computing environments. Therefore, quantization processing needs to be performed on the scale parameter value. The preset selecting condition may be set according to needs. In some embodiments, the preset selecting condition may be that a scale parameter quantization value exceeds a preset quantization threshold. In some embodiments, the preset selecting condition may further be that the scale parameter quantization values are required to be ranked in the first N when sorted in ascending order. In some embodiments, the preset selecting condition may alternatively be that the scale parameter quantization value is required to be data whose value is a maximum N% in all scale parameter quantization values.

In some embodiments, the terminal may determine a quantization stepsize, and perform quantization processing on each scale parameter value according to the quantization stepsize, to obtain a scale parameter quantization value corresponding to each scale parameter value. In some embodiments, the scale parameter quantization values as obtained by the quantization processing are respectively corresponding to the feature elements in the feature data, since each of the scale parameter quantization values is obtained by quantization processing on the scale parameter value corresponding to each feature element in the feature data. In the data encoding process, entropy encoding is implemented only for some feature elements by selecting the scale parameter quantization value, that is, some feature elements are skipped in the entropy encoding process. Therefore, the second device needs to select a subset of scale parameter quantization values according to the same preset selecting condition as that used by the first device.

In some embodiments, the preset selecting condition is that the scale parameter quantization value exceeds a preset quantization threshold. The selecting, according to a preset selecting condition, a subset of scale parameter quantization values from the scale parameter quantization values obtained through quantization processing includes: comparing each scale parameter quantization value obtained through quantization processing with the preset quantization threshold, to obtain a comparison result corresponding to each scale parameter quantization value; and selecting, from the scale parameter quantization values, a scale parameter quantization value whose comparison result indicates that the scale parameter quantization value exceeds the preset quantization threshold, to obtain a subset of scale parameter quantization values.

In some embodiments, when the feature data is obtained by pre-encoding the motion compensation data, the terminal may further perform secondary selection on unselected scale parameter quantization values. In the secondary selection, the terminal may further obtain motion estimation data of a data frame to which the feature data belongs, determine, according to the motion estimation data, a motion estimation value matching a position of a feature element corresponding to each scale parameter quantization value in the unselected scale parameter quantization values, and further select, from the unselected scale parameter quantization values, a scale parameter quantization value whose matching motion estimation value is greater than a motion estimation threshold.

In some embodiments, each scale parameter value is a floating point number, and/or each scale parameter quantization value is an integer. The first device maps a continuous floating point number to a discrete integer in a quantization process, so that when performing quantization in a same manner, the second device may obtain a same scale parameter quantization value. The second device may further obtain the scale parameter quantization value by selecting in a same manner as that of the first device, so that the first device and the second device may perform entropy encoding and entropy decoding on a same feature element, thereby avoiding a situation in which calculation results of the scale parameter value are inconsistent across devices when in an encoding process and a decoding process, resulting in inaccurate reconstructed data obtained through decoding.

In some embodiments of the application, the method may further include operation 408: Perform entropy decoding on the encoded data stream based on the selected scale parameter quantization value, to obtain a corresponding feature element.

In some embodiments, the terminal may re-determine the scale parameter value based on each selected scale parameter value, determine, according to the re-determined scale parameter value, the probability distribution function required for arithmetic coding, and then perform entropy decoding according to the probability distribution function, to obtain the corresponding feature element for restoration of the feature data. That is, the feature data can be restored based on the entropy decoding on the encoded data stream.

During application, the terminal may construct a probability distribution function lookup table between a scale parameter quantization value and a scale parameter value by using the foregoing formula (1), so that the terminal may search the probability distribution function lookup table to obtain the scale parameter value *cale_q* after obtaining the scale parameter quantization value, and determine the probability distribution function required for arithmetic coding according to *cale_q*.

In some embodiments of the application, the method may further include operation 410: Determine, according to the unselected scale parameter quantization value, a position of a feature element that forms the feature data and is not entropy-encoded, and determine a replacement element at the position of the feature elements that is not entropy-encoded.

The scale parameter quantization values that are not selected in the entropy decoding process are also not selected in the entropy encoding. Therefore, the feature elements respectively corresponding to scale parameter values are the feature elements on which entropy encoding is not performed. In this way, in the decoding process, the terminal may determine positions respectively corresponding to the unselected scale parameter quantization values as positions of the feature elements on which entropy encoding is not performed. Since entropy encoding is not performed on the feature elements at these positions, and these feature elements cannot be restored in the entropy decoding process, in some embodiments, the terminal may further determine replacement elements at these positions.

In some embodiments of the application, the method may further include operation 412: Combine the feature element obtained through the entropy decoding and the replacement element, to obtain restored feature data.

In some embodiments, in the decoding process, the terminal may determine, according to the position corresponding to the unselected scale parameter quantization value, the replacement element at the position of the feature element that forms the feature data and is not entropy-encoded, and then combine the feature element obtained through entropy decoding and the replacement element, that is, combine the feature element and the replacement element according to positions of the feature element and the replacement element, to obtain the restored feature data. The terminal may further perform data reconstruction according to the restored feature data, to obtain a reconstructed data frame. The data reconstruction herein is an inverse process of the foregoing pre-encoding.

According to the foregoing data decoding method, the auxiliary encoding information corresponding to the encoded data stream is obtained; the scale parameter value corresponding to each feature element included in feature data is determined according to the auxiliary encoding information; quantization processing is performed on each scale parameter value; a subset of scale parameter quantization values are selected from the scale parameter quantization values obtained through quantization processing according to the preset selecting condition, the selected scale parameter quantization value being greater than the unselected scale parameter quantization value; entropy decoding is performed on the encoded data stream based on the selected scale parameter quantization value, to obtain the corresponding feature element; the replacement element at the position of the feature element, which forms the feature data and is not entropy-encoded, is determined; and the feature element obtained through entropy decoding is combined with the replacement element, to obtain the restored feature data. In the decoding process, because a large scale parameter quantization value may be selected, entropy decoding is performed only based on the selected scale parameter quantization value, so that entropy decoding may be performed on only some feature elements, thereby greatly reducing complexity of entropy encoding and significantly improving data decoding efficiency. In addition, because a selecting process is selecting the scale parameter quantization value obtained through quantization processing according to the preset selecting condition, and the scale parameter value is discretized in the quantization processing process, so that a probability that the selected scale parameter quantization value is consistent with the scale parameter quantization value selected in the encoding process increases, thereby improving accuracy of feature data restored by decoding.

In some embodiments, the performing quantization processing on each scale parameter value includes: determining a quantization stepsize, the quantization stepsize being positively correlated with a difference between a maximum value and a minimum value of the scale parameter value, and the quantization stepsize being negatively correlated with a quantization level set for quantization processing; determining a difference between each scale parameter value and the minimum value; and performing a rounding operation on the quantization stepsize according to the difference corresponding to each scale parameter value, to obtain the scale parameter quantization value corresponding to each scale parameter value.

It can be learned from the foregoing embodiment that, for a feature element on which entropy encoding is not performed, a replacement element needs to be determined. The following embodiment provides two different determining manners of the replacement element.

In some embodiments, each scale parameter quantization value obtained through quantization processing is in one-to-one correspondence with a position of each feature element in the feature data, and the auxiliary encoding information is obtained by performing hyperprior encoding on the feature data. The determining a replacement element at the position of the feature element that is not entropy-encoded includes: obtaining a prediction feature value corresponding to each feature element, the prediction feature value being obtained by predicting a probability distribution parameter value of a corresponding feature element by using the auxiliary encoding information; and determining, for a position of each feature element that is not entropy-encoded, a prediction feature value whose position matches the position of the feature element from the prediction feature values, and determining a replacement element for the position of the feature element according to the determined prediction feature value.

In some embodiments, when predicting the probability distribution parameter value of each feature element by using the auxiliary encoding information, the terminal may further obtain the prediction feature value. The prediction feature value may in some embodiments be a mean of the probability distribution function corresponding to the feature element. Feature elements skipped in the entropy encoding process are basically feature elements corresponding to redundant information, and prediction feature values corresponding to the feature elements are generally more accurate. Therefore, in the decoding process, a feature element on which entropy encoding is not performed may be replaced with a prediction feature value obtained by predicting a probability distribution parameter value of a corresponding feature element. Based on this, after obtaining the prediction feature value, the terminal selects, according to a position of each feature element that is not entropy-encoded, a prediction feature value whose position matches the position of the feature element from each prediction feature value, and determines, according to the selected prediction feature value, the replacement element at the position of the feature element that forms the feature data and is not entropy-encoded.

An example in which the feature data is the feature map is used for description. A prediction feature map may be obtained by estimating the probability distribution of each feature element by using the auxiliary encoding information. A position of each unselected scale parameter quantization value in the map is determined as the position of the feature element that is not entropy-encoded. Further, a prediction feature value located at a same position may be determined from the obtained prediction feature map, and the prediction feature value is determined as a replacement element of the feature element at the same position in the feature map.

In the foregoing embodiment, it is considered that an element skipped in the encoding process is generally of high certainty, a prediction feature value estimated by using the probability distribution may be replaced as a true value, so that a burr phenomenon in the encoding and decoding process can be reduced.

In some embodiments, the feature data is the feature map, and each scale parameter quantization value obtained through quantization processing is in one-to-one correspondence with a position of each feature element in the feature map. The determining a replacement element at the position of the feature element that is not entropy-encoded includes: obtaining additional encoded data of the feature map from the encoded data stream, and performing entropy decoding on the additional encoded data, to obtain a corresponding representative feature element of a region; performing, in the feature map, region division based on a position of a feature element that is not entropy-encoded; and determining, for each region from the region division, a representative feature element whose position is in the region as a replacement element at a position of each feature element that is not entropy-encoded in the region.

In some embodiments, when encoding, the first device may further encode the additional encoded data into the encoded data stream. For a manner of determining the additional encoded data, refer to the foregoing embodiment, and details are not described herein again. Therefore, in the decoding process, the terminal may obtain the additional encoded data of the feature map from the encoded data stream, and perform entropy decoding on the additional encoded data, to obtain a corresponding representative feature element of a region (i.e., a feature element region). It is considered that that in the encoding process, the selected feature element that is not entropy-encoded is a feature element corresponding to the selected scale parameter quantization value, and the feature element that is not entropy-encoded is a feature element corresponding to the unselected scale parameter quantization value. Therefore, a position corresponding to each unselected scale parameter quantization value is determined as a position of the feature element that is not entropy-encoded, and in the feature map, region division is performed based on the position of the feature element that is not entropy encoded in a manner the same as the encoding process. For each region from the region division (i.e., each feature element region), a representative feature element whose position is in the region is determined as a replacement element at the position of each feature element that is not entropy-encoded in the region.

In the foregoing embodiment, the position of the feature element that is not entropy-encoded is determined, and region division is performed based on the position of the feature element that is not entropy-encoded. For each position of the feature element that is not entropy-encoded in each region from the region division, the representative feature element whose position is in the region is determined as the replacement element at the position, so that a more accurate replacement element can be determined.

In some embodiments, this application further provides an application scenario. In the application scenario, the data encoding method and the data decoding method of this application may be configured for encoding and decoding a video. A video application may be installed on a terminal, and the terminal may play the video by using the video application. Referring to FIG. 5, the server may be used as an encoder side to perform data encoding on each video frame in an original video to obtain an encoded data stream and then send the encoded data stream to a terminal. The terminal may be used as a decoder side to decode the encoded data stream to obtain a reconstructed video frame, so as to play a video based on the reconstructed video frame.

Continue to refer to FIG. 5. In some embodiments, encoding on the encoder side and decoding on the decoder side are both implemented based on a video encoding model, and the video encoding model is an AI model. An encoding and decoding process of a video encoding and decoding model mainly includes two stages, which are respectively I-frame encoding and decoding (intra-frame encoding) and P-frame encoding and decoding (inter-frame encoding). Generally, I-frame encoding and decoding is implemented by using an AI image encoding and decoding algorithm. A P-frame encoding and decoding model needs to be designed for characteristics of inter-frame encoding, and is generally divided into two modules: motion estimation and residual compensation. A core idea of these models is to convert an original image into some feature maps that need to be transmitted, and reduce an amount of bytes transmitted by the feature map by using an entropy encoding module, thereby greatly reducing a byte size of video transmission.

In an encoding stage, for an I-frame model, the original image is converted into a to-be-transmitted feature map for transmission, while for a P-frame model, the original image is generally converted into a feature map of motion estimation and a feature map of residual compensation for transmission. In a decoding stage, after receiving the feature map, the I frame model reconstructs an I-frame image. The P-frame model receives the feature map of motion estimation to reconstruct motion estimation, acts on the reference I-frame reconstructed image to obtain a P-frame intermediate result of motion estimation, and finally reconstructs residual compensation information by using the feature map of residual compensation, and acts on the P-frame intermediate result, to obtain a P-frame reconstructed image.

For how to transmit feature maps, entropy encoding estimation is generally used in AI video encoding and decoding technologies for implementation. Entropy encoding is a common data compression technology, and is also a very important part of video encoding and decoding technologies. In video encoding, entropy encoding is generally used to compress residual data, a motion vector, and other encoding parameters in a video encoder, to reduce storage space and transmission bandwidth of video data.

An entropy encoding estimation module is a key module in the AI video encoding and decoding, and an objective of the entropy encoding estimation module is to estimate, according to inputted encoded data, a quantity of bits required for entropy encoding of the inputted encoded data. This module is generally implemented based on a statistical model, and analyzes and models encoded data, to reduce a quantity of bits required as much as possible in the entropy encoding process. Commonly used entropy encoding algorithms include Huffman encoding, arithmetic coding, and the like. The arithmetic coding is used as an example, in the entropy encoding process, arithmetic coding calculation needs to be performed on each feature element (which may be understood as each value in a feature map). To improve reconstruction quality at the decoder side, the feature map generally includes a large quantity of feature elements, and serial element-by-element encoding by using arithmetic coding needs to consume a large amount of time.

According to the data encoding method and the data decoding method provided in the embodiments of this application, arithmetic coding acceleration can be implemented. According to the data encoding method and the data decoding method provided in the embodiments of this application, a scale value (that is, a scale parameter value) estimated by entropy encoding is converted into an index (that is, a scale parameter quantization value), so that the index value may reflect the degree of certainty of the position. For a value with a low index value, the certainty is very high, and can be skipped, thereby reducing a quantity of elements truly encoded. For example, 10,000 elements need to be encoded in original arithmetic coding, and only 2,000 elements with a large index value need to be encoded by using a skip policy, a time consumption of the arithmetic coding is reduced by 4/5, thereby greatly improving a speed of the arithmetic coding. In the decoding process, a value estimated by an entropy encoding model may be determined as a true value of a skipped element, thereby effectively reducing a burr phenomenon in the encoding and decoding process. Specific introduction is made below.

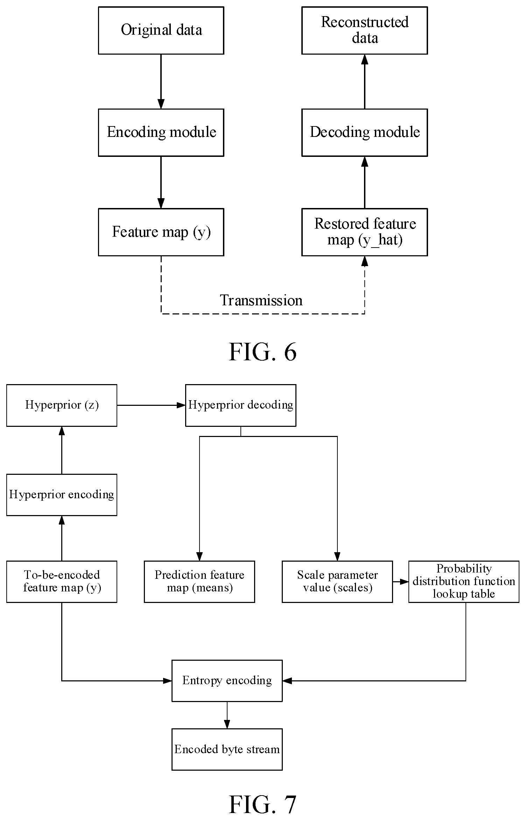

Referring to FIG. 6, for original data (which may be an image, motion estimation, residual estimation, or the like), after an encoding module, first-stage compression may be performed on the original data, to obtain a feature map. The decoder side obtains the restored feature map, and the reconstructed data can be obtained through the decoding module.

For how to transmit the feature maps, second-stage compression, that is, the entropy encoding module, needs to be introduced. Referring to FIG. 7, in the related art, first, hyperprior encoding and hyperprior decoding are performed on a to-be-encoded feature map, to obtain a scale value corresponding to each feature element, then the scale value is quantized into an index, and finally, a probability distribution function is obtained by looking up a mapping relationship table by using the index, thereby implementing information compression on the to-be-encoded feature map. In this process, since there are many feature elements in the to-be-encoded feature map, if some unimportant feature elements are skipped without selecting, arithmetic coding needs to consume long calculation time. Based on this, in the embodiments of this application, during implementation, an amount of actual encoding required may be adjusted according to actual needs, to greatly accelerate the entropy encoding stage and push a real-time implementation of the AI video encoding and decoding algorithm without affecting encoding and decoding quality. When encoding, according to characteristics of the index, only a more important part is encoded, and when 80% to 95% calculation is skipped, accuracy of a model can still be kept without being reduced, thereby greatly reducing time consumption of encoding in the entropy encoding stage. When decoding, a feature map of an important part is obtained by decoding the byte stream, and a feature map of an unimportant part is replaced with a prediction feature map obtained through hyperprior decoding, to obtain a true decoding feature map y_hat used in a subsequent decoding procedure. The operations are described in detail as follows:

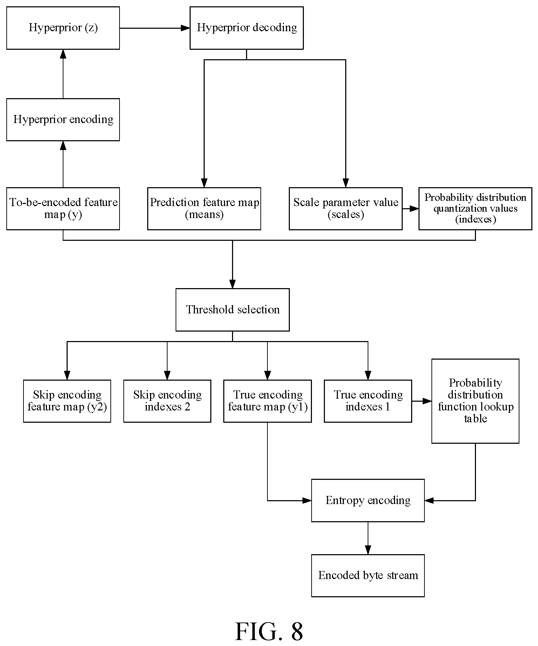

Referring to FIG. 8, an encoding procedure of the encoder side is first described.

The feature map y obtained from the encoding and decoding model is the to-be-encoded feature map. The to-be-encoded feature map may be encoded to obtain a hyperprior z (that is, auxiliary encoding information) by using the hyperprior encoding module, and the hyperprior z is also transmitted to the decoder side in a specific manner. On the encoder side, after the hyperprior z is obtained, hyperprior decoding may be further performed on z, to obtain a prediction feature map means and a scale parameter value scales corresponding to the to-be-encoded feature map y. Means and scales may be understood as estimation for a probability distribution of y, where each value in means is a mean of a probability distribution of each feature element in the feature map y, and scales is a variance of the probability distribution of each feature element in the feature map y. Means and scales help to perform compression with a higher compression rate in a subsequent entropy encoding stage. The scale parameter value scales obtained through hyperprior decoding is first quantized by using the foregoing formula (3) to obtain the scale parameter quantization value indexes.

For the to-be-encoded feature map y and the scale parameter quantization value indexes, which are both feature maps of hxwxc, a threshold parameter th of indexes is set, and a value range of th is 0 to 255. For a position (i, j, k) whose index value exceeds th, a to-be-encoded feature map $y_{i,j,k}$ at the position and a scale parameter quantization value $index_{i,j,k}$ are reserved, thereby forming a true encoding feature map y 1 and a true encoding indexes 1, and for a position whose index value is less than or equal to th, a skip encoding feature map y 2 and a skip encoding indexes 2 are formed. A dimension of the true encoding indexes 1 is the same as that of y 1, and a dimension of the skip encoding indexes 2 is the same as that of y 2. In other words, the true encoding feature map y 1 records a feature element obtained through the selection, the true encoding indexes 1 records a scale parameter quantization value corresponding to each feature element obtained through the selection, the skip encoding feature map y 2 records an unselected feature element, and the skip encoding indexes 2 records a scale parameter quantization value corresponding to each unselected feature element.

Since a large amount of redundant information exists between video frames, most positions can be predicted more accurately, and an index value of a position with a more accurate prediction is small, so that skip may be performed. Different thresholds th are selected, and index values of different ratios may be skipped, so that different degrees of acceleration effect may be achieved. Definitely, different thresholds th may also affect a final reconstruction effect, and needs to be balanced. In the embodiments of this application, when a skip ratio is between 80% and 95%, the acceleration policy does not have a significant impact on the reconstruction effect. An actual threshold may be properly adjusted according to needs.

The entropy encoding module first constructs a mapping relationship table between a scale parameter quantization value and a scale parameter value by using the foregoing Formula (1), and uses the mapping relationship table as a probability distribution function lookup table. For a predicted scale parameter value scales, each element of the scale parameter value scales is in one-to-one correspondence with a value in y. For each scale, a scale parameter quantization value index may be obtained according to the foregoing Formula (2) and Formula (3), and a corresponding scale_q value may be searched from the mapping relationship table by using the index. Since hyperprior encoding is introduced to obtain a prediction feature map means, in the encoding process, a feature element in the feature map may be converted into a probability distribution with a mean of 0 by using the prediction feature map means. Therefore, scale_q may be directly determined as the probability distribution function required for arithmetic coding, so that y may be compressed into a byte stream as few as possible, thereby facilitating subsequent transmission.

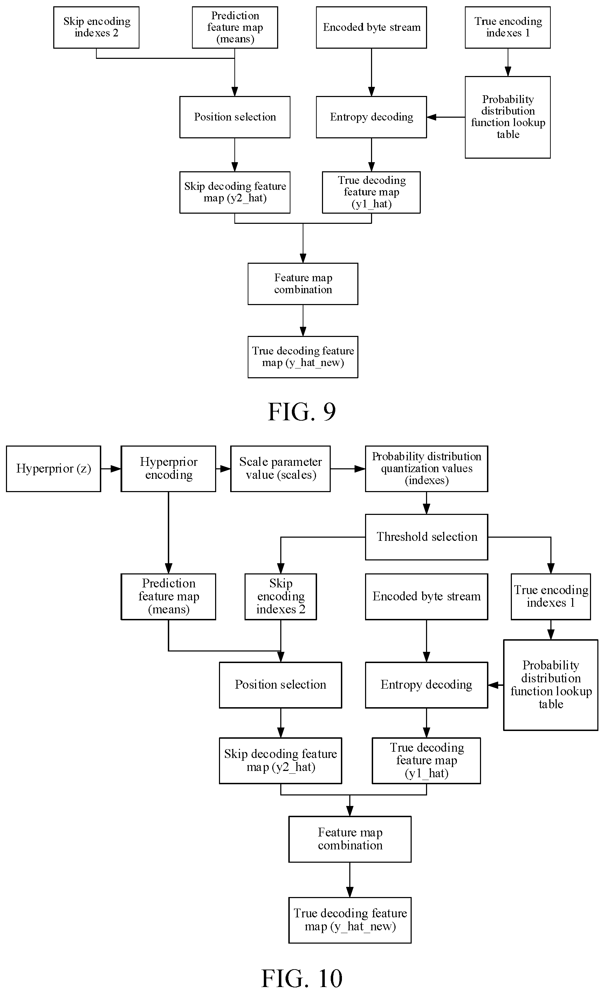

Referring to FIG. 9, a decoding procedure of the encoder side is described next.

The decoding module needs to obtain reconstructed data by decoding complete y_hat. However, in the encoding process, only some elements of the feature map y are encoded as the byte stream for transmission. Therefore, decoding can only decode a part of y. For another part that is not encoded as the byte stream, a value at a corresponding position in the prediction feature map means obtained through hyperprior decoding may be replaced. This not only ensures consistency of the encoding stage and the decoding stage, but also ensures that a true decoding feature map y_hat_new used in decoding is capable of reconstructing to obtain reconstructed data of equivalent quality. For details, refer to Formula (4).

$$y\_hat\_new_{i,j,k} = \begin{cases} y1\_hat_{i,j,k}, & indexes_{i,j,k} > th \\ means_{i,j,k}, & indexes_{i,j,k} <= \text{th} \end{cases} \qquad \text{Formula (4)}$$

Corresponding to entropy encoding, in the entropy decoding stage, a corresponding y1_i_hat value may be obtained by decoding an encoded byte stream one by one according to each index_i value in the obtained true encoding indexes 1, thereby forming a true decoding feature map y1_hat, that is, a first row part in Formula (4).

For the skip encoding indexes 2 already obtained in the encoding process, all element positions (i, j, k) corresponding to the indexes 2 are positions of feature elements on which entropy encoding is not performed. Values of these feature elements in the feature map restored by decoding are not replaced with values in the original skip encoding feature map y 2, but are replaced with values at corresponding positions in the prediction feature map means. Values in the prediction feature map means for replacing feature element positions (i, j, k) corresponding to the indexes 2 are replacement elements corresponding to the feature elements on which entropy encoding is not performed, thereby constructing a skip decoding feature map y2_hat, that is, a second row part in Formula (4).

For y1_hat obtained through decoding and y2_hat obtained through construction, two feature maps are combined (that is, a method of obtaining y_hat_new according to Formula (4)), to obtain the true decoding feature map y_hat_new. The decoding module shown in FIG. 6 is performed on the feature map, to obtain reconstructed data.

Referring to FIG. 10, a decoding procedure of the decoder side is described next.

In the decoding procedure of the decoder side, hyperprior decoding is first performed on a hyperprior z, to obtain a prediction feature map means and a scale parameter value scales that correspond to a to-be-encoded feature map y. The scale parameter value scales obtained from the hyperprior decoding first uses the foregoing Formula (3) to calculate indexes, and obtains a threshold parameter th of indexes. A value range of th may be 0 to 255. A position (i, j, k) whose index value exceeds th is selected, to form a true encoding indexes 1. For a position whose index value is less than or equal to th, a skip encoding indexes 2 is formed. According to the true encoding indexes 1, the mapping relationship table is searched to obtain the probability distribution function required for entropy decoding, and then the encoded byte stream is decoded one by one to obtain a corresponding y1_i_hat value, to construct the true decoding feature map y1_hat. A position (i, j, k) whose index value does not exceed th is selected, to form the skip encoding indexes 2. All element positions (i, j, k) corresponding to indexes 2 are positions of feature elements on which entropy encoding is not performed. Values of these feature elements in the feature map restored by decoding are not replaced with values in the original skip encoding feature map y 2, but are replaced with values at corresponding positions in the prediction feature map means. Values in the prediction feature map means for replacing feature element positions (i, j, k) corresponding to the indexes 2 are replacement elements corresponding to the feature elements on which entropy encoding is not performed. The skip decoding feature map y2_hat may be constructed according to these replacement elements. For y1_hat obtained through decoding and y2_hat obtained through construction, two feature maps are combined (that is, a method of obtaining y_hat_new according to Formula (4)), to obtain the true decoding feature map y_hat_new. In other words, for a feature element whose scale parameter quantization value exceeds a preset threshold th in the feature map y, a value at a corresponding position in the true decoding feature map y_hat_new is obtained through decoding from the encoded byte stream. For a feature element whose scale parameter quantization value does not exceed the preset threshold th in the feature map y, a replacement element is used at a corresponding position in the true decoding feature map y_hat_new, and the replacement element is a value at a position the same as that of the feature element in the prediction feature map means.

Further, the decoder side performs the decoding module shown in FIG. 6 on the feature map, to obtain reconstructed data.

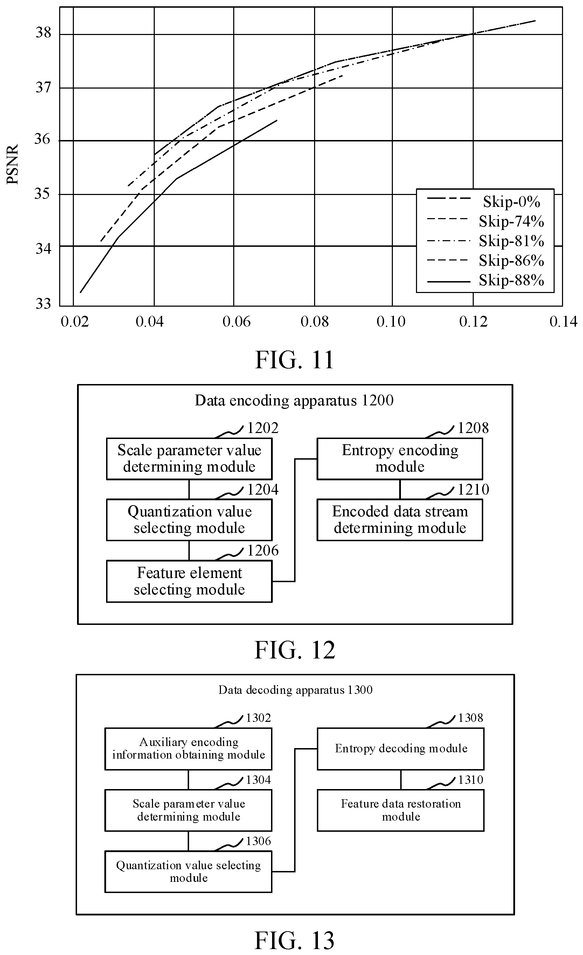

The data encoding method and the data decoding method provided in the embodiments of this application have strong applicability, does not rely on a hardware environment, and can process various types of video encoding and decoding tasks. For the AI video encoding and decoding algorithm that performs entropy encoding compression by using arithmetic coding, the present disclosure can effectively reduce a calculation amount of entropy encoding of the algorithm, thereby improving an encoding and decoding speed, and significantly contributing to real-time implementation of the AI video encoding and decoding. In addition, when an estimated value is used to replace a true value, occurrence of some glitches can usually be avoided, thereby improving smoothness of the reconstructed data. In the present disclosure, the AI video encoding and decoding algorithm is selected for experimental comparison, and a comparison between a reduction ratio of calculation amount of the algorithm after a policy of the present disclosure is used and an impact caused on a final result of the algorithm is provided. In actual use, different thresholds may be selected according to needs, to achieve balance between a speed and an index. The comparison results are shown in FIG. 11, where different curves represent results of different thresholds, skip-0% is a result of not performing skip acceleration, and skip-74%, skip-81%, skip-86%, and skip-88% are respectively effects on arithmetic results caused by reducing a calculation amount of arithmetic coding in different proportions at different thresholds. When skip-74% and the accuracy is basically unchanged, a speed of the arithmetic coding stage may be improved by 5 times, which is very appreciable.

Operations in flowcharts involved in the foregoing embodiments are displayed in sequence based on indication of arrows, but the operations are not necessarily performed in sequence based on a sequence indicated by the arrows. Unless otherwise explicitly specified in this specification, the operations are performed without any strict sequence limit, and may be performed in other sequences. In addition, at least some operations in the flowcharts involved in the foregoing embodiments may include a plurality of operations or a plurality of stages, and these operations or stages are not necessarily performed at a same moment, but may be performed at different moments. The operations or stages are not necessarily performed in sequence, but may be performed by turn or alternately with other operations or at least some operations or stages in other operations.

Based on the same invention concept, some embodiments of this application further provides a data encoding apparatus for implementing the foregoing data encoding method and a data decoding apparatus for implementing the foregoing data decoding method. The implementation solution for solving the problem provided by this apparatus is similar to the implementation solution recorded in the foregoing method. Therefore, for the specific limitations in one or more embodiments of the data encoding apparatus and the data decoding apparatus provided below, reference may be made to the foregoing limitations for the data encoding method and the data decoding method, and the description is not repeated herein again. It is noted that the encoding and decoding apparatuses described with reference to the drawings are merely exemplary, and it is not limited that the encoding/decoding apparatus may include all the modules illustrated in the drawings; rather, the encoding/decoding apparatus of the application may include only some, rather than all, of the modules as illustrated, with reference to the encoding/decoding method as described in the foregoing embodiments.

In some embodiments, as shown in FIG. 12, a data encoding apparatus 1200 is provided. The apparatus may include:

a scale parameter value determining module 1202, configured to obtain auxiliary encoding information of feature data, and determine, according to the auxiliary encoding information, a scale parameter value corresponding to each feature element included in the feature data;

a quantization value selecting module 1204, configured to: perform quantization processing on each scale parameter value, to obtain a scale parameter quantization value corresponding to each scale parameter value; and select a subset of scale parameter quantization values from the scale parameter quantization values according to a preset selecting condition, a selected scale parameter quantization value being greater than an unselected scale parameter quantization value;

a feature element selecting module 1206, configured to: extract, from a plurality of feature elements included in the feature data, a feature element corresponding to each scale parameter quantization value obtained through the selection;

an entropy encoding module 1208, configured to: perform, for each feature element obtained through the extraction, entropy encoding on the feature element based on the scale parameter quantization value corresponding to the feature element, to obtain encoded data corresponding to the feature element; and

an encoded data stream determining module 1210, configured to determine an encoded data stream of the feature data according to the encoded data.

According to the foregoing data encoding apparatus, in the entropy encoding process, a large scale parameter quantization value may be selected according to the preset selecting condition, the feature element is selected according to a selected scale parameter quantization value, entropy encoding is performed on only the selected feature element, and the entropy encoding process of the unselected feature element is skipped. Therefore, the quantity of feature elements on which entropy encoding needs to be performed can be significantly reduced, thereby greatly reducing complexity of entropy encoding, and significantly improving data encoding efficiency.

In some embodiments, the preset selecting condition is that the scale parameter quantization value exceeds a preset quantization threshold. The quantization value selecting module 1204 is further configured to: compare each scale parameter quantization value with the preset quantization threshold, to obtain a comparison result corresponding to each scale parameter quantization value; and select, from the scale parameter quantization values, a scale parameter quantization value whose corresponding comparison result indicates that the scale parameter quantization value exceeds the preset quantization threshold, to obtain a subset of scale parameter quantization values.

In some embodiments, the feature element selecting module 1206 is further configured to: obtain motion estimation data of a data frame to which the feature data belongs, and determine, according to the motion estimation data, a motion estimation value corresponding to each scale parameter quantization value in the a subset of scale parameter quantization values, the motion estimation value matching a position of the feature element corresponding to corresponding respective scale parameter quantization value of the motion estimation value; select, from the a subset of scale parameter quantization values, a scale parameter quantization value whose corresponding motion estimation value is greater than a motion estimation threshold; and extract, from the plurality of feature elements included in the feature data, a feature element corresponding to each selected scale parameter quantization value.

In some embodiments, each scale parameter value is a floating point number, and/or each scale parameter quantization value is an integer.

In some embodiments, the quantization value selecting module 1204 is further configured to: determine a quantization stepsize, the quantization stepsize being positively correlated with a difference between a maximum value and a minimum value of the scale parameter value, and the quantization stepsize being negatively correlated with a maximum quantization level set for quantization processing; determine a difference between each scale parameter value and the minimum value; and perform a rounding operation on the quantization stepsize according to the difference corresponding to each scale parameter value, to obtain the scale parameter quantization value corresponding to each scale parameter value.

In some embodiments, the feature data is a feature map; and the foregoing data encoding apparatus further includes: an additional encoding module, configured to: determine, from the plurality of feature elements included in the feature map, a feature element corresponding to each unselected scale parameter quantization value; perform, according to a position of the feature element corresponding to each unselected scale parameter quantization value in the feature map, region division on feature elements corresponding to unselected scale parameter quantization values, to obtain a plurality of feature element regions; select, for each of the plurality of feature element regions, at least one feature element located at a central position of the feature element region as a representative feature element of the feature element region; and perform entropy encoding on a representative feature element based on a scale parameter quantization value of the representative feature element, to obtain additional encoded data of the feature data.

In some embodiments, the scale parameter value determining module 1202 is further configured to: obtain the feature data, and perform hyperprior encoding on the feature data for reducing a feature dimension, to obtain the auxiliary encoding information of the feature data; and predict, by using the auxiliary encoding information, a probability distribution parameter value of each feature element included in the feature data, to obtain the scale parameter value corresponding to each feature element.

In some embodiments, the feature data is obtained by pre-encoding original data of a current data frame; and the foregoing data encoding apparatus further includes: an original data determining module, configured to: obtain an encoded data stream of a previous data frame, and reconstruct the previous data frame based on the encoded data stream of the previous data frame; perform motion estimation on the current data frame based on the reconstructed previous data frame, to obtain motion estimation data of the current data frame; perform residual compensation estimation on the current data frame based on the motion estimation data, to obtain residual compensation data of the current data frame; and determine the motion estimation data and the residual compensation data as original data of the current data frame.

In some embodiments, the original data determining module is further configured to: perform entropy decoding on the encoded data stream of the previous data frame based on a scale parameter quantization value selected in a process of encoding feature data of the previous data frame, to obtain a corresponding feature element; determine a replacement element at a position of a feature element that forms feature data of the previous data frame and on which entropy encoding is not performed; combine the feature element obtained through entropy decoding and the replacement element, to obtain feature data restored for the previous data frame; and perform data reconstruction based on the feature data restored for the previous data frame, to obtain a reconstructed previous data frame.

In some embodiments, as shown in FIG. 13, a data decoding apparatus 1300 is provided. The apparatus may include:

an auxiliary encoding information obtaining module 1302, configured to obtain auxiliary encoding information corresponding to an encoded data stream, the encoded data stream being obtained by encoding some feature elements of feature data according to the auxiliary encoding information;

a scale parameter value determining module 1304, configured to determine, according to the auxiliary encoding information, a scale parameter value corresponding to each feature element included in the feature data;

a quantization value selecting module 1306, configured to: perform quantization processing on each scale parameter value, to obtain a scale parameter quantization value corresponding to each scale parameter value; and select a subset of scale parameter quantization values from the scale parameter quantization values according to a preset selecting condition, a selected scale parameter quantization value being greater than an unselected scale parameter quantization value;

an entropy decoding module 1308, configured to perform entropy decoding on the encoded data stream based on the selected scale parameter quantization value, to obtain a corresponding feature element; and determine, according to the unselected scale parameter quantization value, a position of a feature element that forms the feature data and is not entropy-encoded, and determining a replacement element at the position of the feature element that is not entropy-encoded; and

a feature data restoration module 1310, configured to combine the feature element obtained through entropy decoding and the replacement element, to obtain restored feature data.

According to the foregoing data decoding apparatus, in the decoding process, because a large scale parameter quantization value may be selected, entropy decoding is performed only based on the selected scale parameter quantization value, so that entropy decoding may be performed on only some feature elements, thereby greatly reducing complexity of entropy encoding and significantly improving data decoding efficiency. In addition, because a selecting process is selecting the scale parameter quantization value obtained through quantization processing according to the preset selecting condition, and the scale parameter value is discretized in the quantization processing process, so that a probability that the selected scale parameter quantization value is consistent with the scale parameter quantization value selected in the encoding process increases, thereby improving accuracy of feature data restored by decoding.

In some embodiments, the entropy decoding module is further configured to: obtain motion estimation data reconstructed from a data frame to which the feature data belongs, and determine, according to the motion estimation data, a motion estimation value corresponding to each scale parameter quantization value in the subset of scale parameter quantization values, the motion estimation value matching a position of a feature element corresponding to a scale parameter quantization value of the motion estimation value; select, from the subset of scale parameter quantization values, a scale parameter quantization value whose corresponding motion estimation value is greater than a motion estimation threshold; and perform entropy decoding on the encoded data stream by using the selected scale parameter quantization value, to obtain the corresponding feature element.

In some embodiments, each scale parameter value is a floating point number, and/or each scale parameter quantization value is an integer.

In some embodiments, the quantization value selecting module is configured to: determine a quantization stepsize, the quantization stepsize being positively correlated with a difference between a maximum value and a minimum value of the scale parameter value, and the quantization stepsize being negatively correlated with a quantization level set for quantization processing; determine a difference between each scale parameter value and the minimum value; and perform a rounding operation on the quantization stepsize according to the difference corresponding to each scale parameter value, to obtain the scale parameter quantization value corresponding to each scale parameter value.

In some embodiments, the entropy decoding module is further configured to: obtain a prediction feature value corresponding to each feature element, the prediction feature value being obtained by predicting a probability distribution parameter value of a corresponding feature element by using the auxiliary encoding information; and determine, for a position of each feature element that is not entropy-encoded d, a prediction feature value whose position matches the position from the prediction feature values, and determining a replacement element for the position of the feature element according to the determined prediction feature value.

In some embodiments, the entropy decoding module is further configured to: obtain additional encoded data of the feature map from the encoded data stream, and perform entropy decoding on the additional encoded data, to obtain a corresponding representative feature element of a region; perform, in the feature map, region division based on a position of a feature element on which entropy encoding is not performed; and determine, for each region from the region division, a representative feature element whose position is in the region as a replacement element at a position of each feature element that is not entropy-encoded.

The modules in the foregoing data encoding apparatus and data decoding apparatus may be implemented entirely or partially by software, hardware, or a combination thereof. The foregoing modules may be built in or independent of a processor of a computer device in a hardware form, or may be stored in a memory of a computer device in a software form, so that the processor invokes and performs an operation corresponding to each of the foregoing modules.

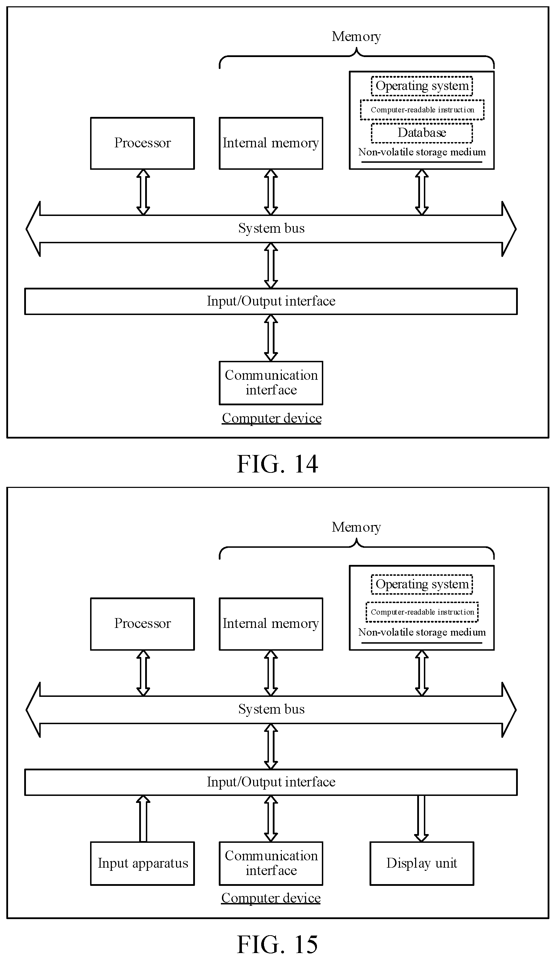

In some embodiments, a computer device is provided. The computer device may be a server, and an internal structure diagram thereof may be shown in FIG. 14. The computer device includes a processor, a memory, an input/output (I/O for short) interface, and a communication interface. The processor, the memory, and the input/output interface are connected through a system bus, and the communication interface is connected to the system bus through the input/output interface. The processor of the computer device is configured to provide computing and control capabilities. The memory of the computer device includes a non-volatile storage medium and an internal memory. The non-volatile storage medium stores an operating system, computer-readable instructions, and a database. The internal memory provides an environment for running of the operating system and the computer-readable instructions in the non-volatile storage medium. The database of the computer device is configured to store the encoded data stream or reconstructed data obtained by decoding. The input/output interface of the computer device is configured to exchange information between the processor and an external device. The communication interface of the computer device is configured to communicate with an external terminal through a network connection. The computer-readable instructions are executed by the processor to implement a data encoding method or a data decoding method.

In some embodiments, a computer device is provided. The computer device may be a terminal, and an internal structure diagram thereof may be shown in FIG. 15. The computer device includes a processor, a memory, an input/output interface, a communication interface, a display unit, and an input apparatus. The processor, the memory, and the input/output interface are connected through a system bus, and the communication interface, the display unit, and the input apparatus are connected to the system bus through the input/output interface. The processor of the computer device is configured to provide computing and control capabilities. The memory of the computer device includes a non-volatile storage medium and an internal memory. The non-volatile storage medium stores an operating system and computer-readable instructions. The internal memory provides an environment for running of the operating system and the computer-readable instructions in the non-volatile storage medium. The input/output interface of the computer device is configured to exchange information between the processor and an external device. The communication interface of the computer device is configured to communicate with an external terminal in a wired or a wireless manner, and the wireless manner can be implemented by using WIFI, a mobile cellular network, a near field communication (NFC), or other technologies. The computer-readable instructions are executed by the processor to implement a data encoding method or a data decoding method. The display unit of the computer device is configured to form a visually visible picture, and may be a display screen, a projection apparatus, or a virtual reality imaging apparatus. The display screen may be a liquid crystal display screen or an electronic ink display screen. The input apparatus of the computer device may be a touch layer covering the display screen, or may be a key, a trackball, or a touch pad arranged on a housing of the computer device, or may be an external keyboard, a touch pad, a mouse, or the like.

A person skilled in the art may understand that, the structures shown in FIG. 14 and FIG. 15 are only a block diagram of a part of a structure related to a solution of this application and does not limit the computer device to which the solution of this application is applied. In some embodiments, the computer device may include more or fewer components than those in the drawings, or some components are combined, or a different component arrangement is used.

In some embodiments, a computer device is provided, including a memory and a processor, the memory having computer-readable instructions stored therein, the processor, when executing the computer-readable instructions, implementing the operations of the data encoding method or the data decoding method according to any one of the foregoing embodiments.

In some embodiments, a computer-readable storage medium is provided, having computer-readable instructions stored therein, the computer-readable instructions, when executed by a processor, implementing the operations of the data encoding method or the data decoding method according to any one of the foregoing embodiments.

In some embodiments, a computer program product is provided, having computer-readable instructions stored therein, the computer-readable instructions, when executed by a processor, implementing the operations of the data encoding method or the data decoding method according to any one of the foregoing embodiments.

The user information (including, but not limited to, user equipment information, user personal information, and the like) and the data (including, but not limited to, data for analysis, stored data, displayed data, and the like) involved in this application all are information and data authorized by the user or fully authorized by each party, and the acquisition, use, and processing of relevant data need to comply with relevant laws and regulations of relevant countries and regions.

A person of ordinary skill in the art may understand that all or some of the procedures of the methods of the foregoing embodiments may be implemented by using computer-readable instructions instructing relevant hardware. The computer-readable instructions may be stored in a non-volatile computer-readable storage medium. When the computer-readable instructions are executed, the procedures of the embodiments of the foregoing methods may be included. Any reference to a memory, a database, or another medium used in the embodiments provided in this application may include at least one of a non-volatile memory and a volatile memory. The non-volatile memory may include a read-only memory (ROM), a magnetic tape, a floppy disk, a flash memory, an optical memory, a high-density embedded non-volatile memory, a resistive random access memory (ReRAM), a magnetoresistive random access memory (MRAM), a ferroelectric random access memory (FRAM), a phase change memory (PCM), a graphene memory, and the like. The volatile memory may include a random access memory (RAM) or an external cache. For the purpose of description instead of limitation, the RAM may be in a plurality of forms, such as a static random access memory (SRAM) or a dynamic random access memory (DRAM). The database involved in the embodiments provided in this application may include at least one of a relational database and a non-relational database. The non-relational database may include a blockchain-based distributed database, but is not limited thereto. The processor involved in the embodiments provided in this application may be a general-purpose processor, a central processing unit, a graphics processing unit, a digital signal processor, a programmable logic device, a quantum computing-based data processing logic device, and are not limited thereto.

The technical features in the foregoing embodiments may be randomly combined. For concise description, not all possible combinations of the technical features in the embodiments are described. However, provided that combinations of the technical features do not conflict with each other, the combinations of the technical features are considered as falling within the scope recorded in this specification.

The foregoing embodiments only describe several implementations of this application, which are described specifically and in detail, but cannot be construed as a limitation to the patent scope of this application. A person of ordinary skill in the art may make various changes and improvements without departing from the ideas of this application, which shall all fall within the protection scope of this application. Therefore, the protection scope of this patent application is subject to the protection scope of the appended claims.

## Claims

1. A data encoding method, comprising:

   obtaining a plurality of scale parameter quantization values by performing quantization processing on a scale parameter value corresponding to each of a plurality of feature elements in predetermined data, the scale parameter value defining a probability distribution corresponding to a respective one of the plurality of feature elements;

   selecting, according to a preset selecting condition, a subset of scale parameter quantization values from the plurality of scale parameter quantization values; and

   performing, for each feature element corresponding to a respective one of the subset of scale parameter quantization values, entropy encoding on the feature element based on the respective scale parameter quantization value, for determination of an encoded data stream of the predetermined data.

2. The method according to claim 1, wherein the preset selecting condition is that a scale parameter quantization value exceeds a preset quantization threshold; and

   the selecting a subset of scale parameter quantization values from scale parameter quantization values respectively corresponding to a plurality of feature elements in predetermined data comprises:

   comparing each scale parameter quantization value with the preset quantization threshold, to obtain a comparison result corresponding to each scale parameter quantization value; and

   selecting, from the scale parameter quantization values, a scale parameter quantization value whose corresponding comparison result indicates that the scale parameter quantization value exceeds the preset quantization threshold, to obtain the subset of scale parameter quantization values.

3. The method according to any one of claims 1 and 2, wherein each feature element corresponding to a respective one of the subset of scale parameter quantization values is determined by:

   obtaining motion estimation data of a data frame to which the predetermined data belongs, and determining, according to the motion estimation data, a motion estimation value corresponding to each scale parameter quantization value in the subset of scale parameter quantization values, the motion estimation value matching a position of the feature element corresponding to a respective scale parameter quantization value of the motion estimation value;

   selecting, from the subset of scale parameter quantization values, a scale parameter quantization value whose corresponding motion estimation value is greater than a motion estimation threshold; and

   extracting, from the plurality of feature elements comprised in the feature data, a feature element corresponding to each selected scale parameter quantization value corresponding to a motion estimation value greater than the motion estimation threshold.

4. The method according to any one of claims 1 to 3, wherein each scale parameter quantization value is an integer.

5. The method according to any one of claims 1 to 4, wherein the scale parameter quantization value is obtained by quantization processing comprising :

determining a quantization stepsize, the quantization stepsize being positively correlated with a difference between a maximum value and a minimum value of the scale parameter value corresponding to each feature element in the predetermined data, and the quantization stepsize being negatively correlated with a maximum quantization level set for the quantization processing;

determining a difference between each scale parameter value and the minimum value; and

performing a rounding operation on the quantization stepsize according to the difference corresponding to each scale parameter value, to obtain the scale parameter quantization value corresponding to each scale parameter value.

6. The method according to any one of claims 1 to 5, wherein the predetermined data is a feature map; and the method further comprises:

determining, from the plurality of feature elements comprised in the feature map, a feature element corresponding to each unselected scale parameter quantization value;

performing, according to a position of the feature element corresponding to each unselected scale parameter quantization value in the feature map, region division on feature elements corresponding to unselected scale parameter quantization values, to obtain a plurality of feature element regions;

selecting, for each of the plurality of feature element regions, at least one feature element located at a central position of the feature element region as a representative feature element of the feature element region; and

performing entropy encoding on the representative feature element based on a scale parameter quantization value of the representative feature element, to obtain additional encoded data of the predetermined data.

7. The method according to any one of claims 1 to 6, further comprising:

obtaining the predetermined data, and performing hyperprior encoding on the predetermined data for reducing a feature dimension, to obtain auxiliary encoding information of the predetermined data;

predicting, by using the auxiliary encoding information, a probability distribution parameter value of each feature element comprised in the predetermined data, to obtain the scale parameter value corresponding to each feature element.

8. The method according to any one of claims 1 to 7, wherein the predetermined data is obtained by pre-encoding original data of a current data frame; and the method further comprises:

obtaining an encoded data stream of a previous data frame, and reconstructing the previous data frame based on the encoded data stream of the previous data frame;

performing motion estimation on the current data frame based on the reconstructed previous data frame, to obtain motion estimation data of the current data frame;

performing residual compensation estimation on the current data frame based on the motion estimation data, to obtain residual compensation data of the current data frame; and

determining the motion estimation data and the residual compensation data as the original data of the current data frame.

9. The method according to claim 8, wherein the reconstructing the previous data frame based on the encoded data stream of the previous data frame comprises:

performing entropy decoding on the encoded data stream of the previous data frame based on a scale parameter quantization value selected in a process of encoding predetermined data of the previous data frame, to obtain a corresponding feature element;

determining a replacement element at a position of a feature element that forms the predetermined data of the previous data frame and is not entropy-encoded;

combining the feature element obtained through entropy decoding and the replacement element, to obtain predetermined data restored for the previous data frame; and

performing data reconstruction based on the predetermined data restored for the previous data frame, to obtain the reconstructed previous data frame.

10. A data decoding method, comprising:

obtaining a plurality of scale parameter quantization values by performing quantization processing on a scale parameter value corresponding to each of a plurality of feature elements in an encoded data stream of predetermined data, the scale parameter value defining a probability distribution corresponding to a respective one of the plurality of feature elements;

selecting, according to a preset selecting condition, a subset of scale parameter quantization values from the plurality of scale parameter quantization values; and

performing entropy decoding on the encoded data stream based on each selected scale parameter quantization value, for restoration of the predetermined data.

11. The method according to claim 10, wherein the performing entropy decoding on the encoded data stream based on each selected scale parameter quantization value:

obtaining motion estimation data reconstructed from a data frame to which the predetermined data belongs, and determining, according to the motion estimation data, a motion estimation value corresponding to each scale parameter quantization value in the subset of scale parameter quantization values, the motion estimation value matching a position of a feature element corresponding to a respective scale parameter quantization value of the motion estimation value;

selecting, from the subset of scale parameter quantization values, a scale parameter quantization value whose corresponding motion estimation value is greater than a motion estimation threshold; and

performing entropy decoding on the encoded data stream by using the selected scale parameter quantization value, to obtain a corresponding feature element.

12. The method according to any one of claims 10 and 11, wherein each scale parameter quantization value is an integer.

13. The method according to any one of claims 10 to 12, wherein the scale parameter quantization value is obtained by quantization processing comprising:

determining a quantization stepsize, the quantization stepsize being positively correlated with a difference between a maximum value and a minimum value of a scale parameter value, and the quantization stepsize being negatively correlated with a quantization level set for the quantization processing;

determining a difference between each scale parameter value and the minimum value; and

performing a rounding operation on the quantization stepsize according to the difference corresponding to each scale parameter value, to obtain the scale parameter quantization value corresponding to each scale parameter value.

14. The method according to any one of claims 10 to 13, wherein the method further comprises:

determining, according to an unselected scale parameter quantization value in the scale parameter quantization values, a position of a feature element that forms the predetermined data and is not entropy-encoded;

determining a replacement element at the position of the feature element that is not entropy-encoded; and

combining a feature element obtained through the entropy decoding and the replacement element, to obtain restored predetermined data,

wherein the determining a replacement element at the position of the feature element that is not entropy-encoded comprises:

obtaining a prediction feature value corresponding to each feature element, the prediction feature value being obtained by predicting a probability distribution parameter value of a corresponding feature element; and

determining, for a position of each feature element that is not entropy-encoded, a prediction feature value whose position matches the position of the feature element from the prediction feature values, and determining a replacement element for the position of the feature element according to the determined prediction feature value.

15. The method according to any one of claims 10 to 13, wherein the predetermined data is a feature map; and the method further comprises:

determining, according to an unselected scale parameter quantization value in the scale parameter quantization values, a position of a feature element that forms the predetermined data and is not entropy-encoded;

determining a replacement element at the position of the feature element that is not entropy-encoded; and

combining a feature element obtained through the entropy decoding and the replacement element, to obtain restored predetermined data,

wherein the determining a replacement element at the position of the feature element that is not entropy-encoded comprises:

obtaining additional encoded data of the feature map from the encoded data stream, and performing entropy decoding on the additional encoded data, to obtain a corresponding representative feature element of a region;

performing, in the feature map, region division based on the position of the feature element that is not entropy-encoded; and

determining, for each region from the region division, a representative feature element located in the region as a replacement element at a position of each feature element that is not entropy-encoded in the region.

16. A data encoding apparatus, comprising:

a quantization value selecting module, configured to obtain a plurality of scale parameter quantization values by performing quantization processing on a scale parameter value corresponding to each of a plurality of feature elements in predetermined data, the scale parameter value defining a probability distribution corresponding to a respective one of the plurality of feature elements; and select, according to a preset selecting condition, a subset of scale parameter quantization values from the plurality of scale parameter quantization values; and

an entropy encoding module, configured to perform, for each feature element corresponding to a respective one of the subset of scale parameter quantization values, entropy encoding on the feature element based on the respective scale parameter quantization value, for determination of an encoded data stream of the predetermined data.

17. A data decoding apparatus, comprising:

a quantization value selecting module, configured to obtain a plurality of scale parameter quantization values by performing quantization processing on a scale parameter value corresponding to each of a plurality of feature elements in an encoded data stream of predetermined data, the scale parameter value defining a probability distribution corresponding to a respective one of the plurality of feature elements; and select, according to a preset selecting condition, a subset of scale parameter quantization values from the plurality of scale parameter quantization values; and

an entropy decoding module, configured to perform entropy decoding on the encoded data stream based on each selected scale parameter quantization value, for restoration of the predetermined data.

18. A computer device, comprising a memory and a processor, the memory having computer-readable instructions stored therein, and the processor, when executing the computer-readable instructions, implementing the operations of the method according to any one of claims 1 to 9 or claims 10 to 15.

19. A computer-readable storage medium, having computer-readable instructions stored therein, the computer-readable instructions, when executed by a processor, implementing the operations of the method according to any one of claims 1 to 9 or claims 10 to 15.

20. A computer program product, comprising computer-readable instructions, the computer-readable instructions, when executed by a processor, implementing the operations of the method according to any one of claims 1 to 9 or claims 10 to 15.

104

Server

Data storage system

... 

Network

102

Terminal

For example

## FIG. 1

Operation 202

Obtain auxiliary encoding information of feature data, and determine, according to the auxiliary encoding information, a scale parameter value corresponding to each feature element included in the feature data

Operation 204

Perform quantization processing on each scale parameter value, to obtain a scale parameter quantization value corresponding to each scale parameter value, and select a subset of scale parameter quantization values from the scale parameter quantization values according to a preset selecting condition, a selected scale parameter quantization value being greater than an unselected scale parameter quantization value

Operation 206

Extract, from a plurality of feature elements included in the feature data, a feature element corresponding to each scale parameter quantization value obtained through selection

Operation 208

Perform, for each feature element obtained through the extraction, entropy encoding on the feature element based on the scale parameter quantization value corresponding to the feature element, to obtain encoded data corresponding to the feature element

Operation 210

Determine an encoded data stream of the feature data according to the encoded data

## FIG. 2

Operation 302

Perform entropy decoding on encoded data stream of a previous data frame based on a scale parameter quantization value selected in a process of encoding feature data of the previous data frame, to obtain a corresponding feature element

Operation 304

Determine a replacement element at a position of a feature element that forms feature data of the previous data frame and is not entropy-encoded

Operation 306

Combine the feature element obtained through entropy decoding and the replacement element, to obtain feature data restored for the previous data frame

Operation 308

Perform data reconstruction based on the feature data restored for the previous data frame, to obtain a reconstructed previous data frame

Operation 310

Perform motion estimation on a current data frame based on the reconstructed previous data frame, to obtain motion estimation data of the current data frame

Operation 312

Perform residual compensation estimation on the current data frame based on the motion estimation data, to obtain residual compensation data of the current data frame, and pre-encode the residual compensation data to obtain the feature data

Operation 314

Perform hyperprior encoding on the feature data for reducing a feature dimension, to obtain auxiliary encoding information of the feature data

Operation 316

Predict, by using the auxiliary encoding information, a probability distribution parameter value of each feature element included in the feature data, to obtain a scale parameter value corresponding to each feature element

Operation 318

Determine a quantization stepsize, and determine a difference between each scale parameter value and a minimum value of the scale parameter value

Operation 320

Perform a rounding operation on the quantization stepsize according to the difference corresponding to each scale parameter value, to obtain the scale parameter quantization value corresponding to each scale parameter value

Operation 322

Compare each scale parameter quantization value obtained through quantization processing with a preset quantization threshold, and select a scale parameter quantization value whose comparison result indicates that the scale parameter quantization value exceeds the preset quantization threshold, to obtain a subset of scale parameter quantization values

Operation 324

Determine, according to the motion estimation data of the current data frame, a motion estimation value matching a position of a feature element corresponding to each scale parameter quantization value in the subset of scale parameter quantization values obtained through the selection

Operation 326

Select a scale parameter quantization value whose matching motion estimation value is greater than a motion estimation threshold from the subset of scale parameter quantization values obtained through the selection

Operation 328

Extract, from a plurality of feature elements included in the feature data, a feature element corresponding to each scale parameter quantization value obtained through the selection

Operation 330

Perform, for each feature element obtained through the extraction, entropy encoding on the feature element based on the scale parameter quantization value corresponding to the feature element, to obtain encoded data corresponding to the feature element, and determine an encoded data stream of the feature data according to the encoded data

FIG. 3

Operation 402

Obtain auxiliary encoding information corresponding to an encoded data stream

Operation 404

Determine, according to the auxiliary encoding information, a scale parameter value corresponding to each feature element included in feature data

Operation 406

Perform quantization processing on each scale parameter value, to obtain a scale parameter quantization value corresponding to each scale parameter value, and select a subset of scale parameter quantization values from the scale parameter quantization values according to a preset selecting condition, a selected scale parameter quantization value being greater than an unselected scale parameter quantization value

Operation 408

Perform entropy decoding on the encoded data stream based on the selected scale parameter quantization value, to obtain a corresponding feature element

Operation 410

Determine, according to the unselected scale parameter quantization value, a position of a feature element that forms the feature data and on which entropy encoding is not performed, and determine a replacement element at the position the feature element that is not entropy-encoded

Operation 412

Combine the feature element obtained through the entropy decoding and the replacement element, to obtain restored feature data

FIG. 4

Original video → Video encoding and decoding model → Encoded data stream

Encoder side

Encoded data stream → Video encoding and decoding model → Reconstructed video frame

Decoder side

FIG. 5

Original data

Encoding module

Feature map (y)

Reconstructed data

Decoding module

Restored feature map (y_hat)

Transmission

## FIG. 6

Hyperprior (z)

Hyperprior decoding

Hyperprior encoding

To-be-encoded feature map (y)

Prediction feature map (means)

Scale parameter value (scales)

Probability distribution function lookup table

Entropy encoding

Encoded byte stream

## FIG. 7

FIG. 8

Skip encoding indexes 2 → Position selection

Prediction feature map (means) → Position selection

Encoded byte stream → Entropy decoding

True encoding indexes 1 → Probability distribution function lookup table → Entropy decoding

Position selection → Skip decoding feature map (y2_hat)

Entropy decoding → True decoding feature map (y1_hat)

Skip decoding feature map (y2_hat), True decoding feature map (y1_hat) → Feature map combination → True decoding feature map (y_hat_new)

## FIG. 9

Hyperprior (z) → Hyperprior encoding → Scale parameter value (scales) → Probability distribution quantization values (indexes) → Threshold selection

Hyperprior encoding → Prediction feature map (means)

Threshold selection → Skip encoding indexes 2, True encoding indexes 1

Prediction feature map (means), Skip encoding indexes 2 → Position selection

Encoded byte stream → Entropy decoding

True encoding indexes 1 → Probability distribution function lookup table → Entropy decoding

Position selection → Skip decoding feature map (y2_hat)

Entropy decoding → True decoding feature map (y1_hat)

Skip decoding feature map (y2_hat), True decoding feature map (y1_hat) → Feature map combination → True decoding feature map (y_hat_new)

## FIG. 10

FIG. 11

FIG. 12

FIG. 13

Memory

Operating system

Computer-readable instruction

Database

Non-volatile storage medium

Processor

Internal memory

System bus

Input/Output interface

Communication interface

Computer device

## FIG. 14

Memory

Operating system

Computer-readable instruction

Non-volatile storage medium

Processor

Internal memory

System bus

Input/Output interface

Input apparatus

Communication interface

Display unit

Computer device

## FIG. 15

## INTERNATIONAL SEARCH REPORT

| International application No. |
|---|
| **PCT/CN2023/131492** |

| A. | CLASSIFICATION OF SUBJECT MATTER |
|---|---|

H04N19/172(2014.01)i; H04N19/159(2014.01)i; H03M7/40(2006.01)i

According to International Patent Classification (IPC) or to both national classification and IPC

| B. | FIELDS SEARCHED |
|---|---|

Minimum documentation searched (classification system followed by classification symbols)

IPC: H04N; G06F; H03M

Documentation searched other than minimum documentation to the extent that such documents are included in the fields searched

Electronic data base consulted during the international search (name of data base and, where practicable, search terms used)

CNKI, CNTXT, WPI, VEN, EXTXT, USTXT, IEEE: 数据, 编码, 解码, 尺度, 量化, 熵, 元素, data, encoding, decoding, scale, quantization, entropy, element

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 116979971 A (TENCENT TECHNOLOGY (SHENZHEN) CO., LTD.) 31 October 2023 (2023-10-31)<br>description, paragraphs [0036]-[0093], and figures 1-5 | 1-20 |
| A | CN 113613004 A (BAIGUOYUAN TECHNOLOGY (SINGAPORE) PTE LTD.) 05 November 2021 (2021-11-05)<br>description, paragraphs [0037]-[0092], and figures 1-6 | 1-20 |
| A | CN 111432207 A (BEIHANG UNIVERSITY) 17 July 2020 (2020-07-17)<br>entire document | 1-20 |
| A | CN 115442609 A (HUAWEI TECHNOLOGIES CO., LTD.) 06 December 2022 (2022-12-06)<br>entire document | 1-20 |
| A | WO 2022088631 A1 (GUANGDONG OPPO MOBILE TELECOMMUNICATIONS CORP., LTD.) 05 May 2022 (2022-05-05)<br>entire document | 1-20 |
| A | WO 2011052216 A1 (PANASONIC CORP.) 05 May 2011 (2011-05-05)<br>entire document | 1-20 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 January 2024** | **23 January 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

| International application No. |
| --- |
| **PCT/CN2023/131492** |

| Patent document cited in search report | | | Publication date (day/month/year) | Patent family member(s) | | | Publication date (day/month/year) |
| --- | --- | --- | --- | --- | --- | --- | --- |
| CN | 116979971 | A | 31 October 2023 | None | | | |
| CN | 113613004 | A | 05 November 2021 | WO | 2023040600 | A1 | 23 March 2023 |
| CN | 111432207 | A | 17 July 2020 | None | | | |
| CN | 115442609 | A | 06 December 2022 | WO | 2022253249 | A1 | 08 December 2022 |
| WO | 2022088631 | A1 | 05 May 2022 | TW | 202218428 | A | 01 May 2022 |
| | | | | CN | 114501010 | A | 13 May 2020 |
| WO | 2011052216 | A1 | 05 May 2011 | TW | 201143448 | A | 01 December 2011 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023105493790